# EUROPEAN PATENT APPLICATION

(11) **EP 4 811 361 A1**
(43) Date of publication of application: **23.09.2026**
(21) Application number: 25196009.2
(22) Date of filing: 14.08.2025
(51) Int. Cl.: G11C 11/56, G11C 16/34

(54) **NONVOLATILE MEMORY DEVICE AND CONTROL METHOD THEREOF**

(30) Priority: 17.03.2025 JP 2025042415
(71) Applicant: Kioxia Corporation, Tokyo 108-0023 (JP)
(72) Inventor: Kurosawa, Yasuhiko, Tokyo, 108-0023 (JP)
(74) Representative: Marks & Clerk LLP

(57) **Abstract**

According to one embodiment, a control circuit (24) executes a read operation of simultaneously selecting two adjacent word lines (WL(n+1), WL(n-1)) adjacent to a read target word line (WL(n)) using a first voltage for determining whether or not threshold voltages of two adjacent memory cells connected respectively to the two adjacent word lines (WL(n+1), WL(n-1)) are threshold voltages of a first state or lower. Based on the result of the read operation, the control circuit (24) selects one date among data which is read from a memory cell of the read target word line (WL(n)) using first read voltages and data which is read from the memory cell of the read target word line (WL(n)) using second read voltages that are respectively lower than the first read voltages.

## Description

### CROSS-REFERENCE TO RELATED APPLICATIONS

This application is based upon and claims the benefit of priority from Japanese Patent Application No. 2025-042415, filed March 17, 2025.

### FIELD

Embodiments described herein relate generally to a nonvolatile memory device and a control method thereof.

### BACKGROUND

NAND flash memory is known as a nonvolatile memory device.

In nonvolatile memory devices, cell-to-cell interference may occur, in which a threshold voltage of a memory cell connected to a certain word line is shifted in accordance with a threshold voltage of an adjacent memory cell connected to an adjacent word line.

### BRIEF DESCRIPTION OF THE DRAWINGS

FIG. 1 is a block diagram illustrating an example of a configuration of a memory system according to a first embodiment.
FIG. 2 is a block diagram illustrating an example of a hardware configuration of a memory controller provided in the memory system according to the first embodiment.
FIG. 3 is a block diagram illustrating an example of a hardware configuration of a nonvolatile memory device provided in the memory system according to the first embodiment.
FIG. 4 is a diagram illustrating an example of a circuit configuration of a memory cell array provided in the nonvolatile memory device according to the first embodiment.
FIG. 5 is a diagram illustrating an example of a circuit configuration of a sense amplifier module and a data register provided in the nonvolatile memory device according to the first embodiment.
FIG. 6 is a schematic view illustrating an example of threshold voltage distribution of memory cell transistors and data assignment in the nonvolatile memory device according to the first embodiment.
FIG. 7 is a block diagram illustrating an example of a read operation for reading data from the nonvolatile memory device according to the first embodiment.
FIG. 8 is a block diagram illustrating an example of a read operation of simultaneously selecting two adjacent word lines, which is executed in the nonvolatile memory device according to the first embodiment.
FIG. 9 is a diagram illustrating a combination of states of two adjacent memory cells connected respectively to two adjacent word lines, which is determined by the read operation of simultaneously selecting two adjacent word lines in the nonvolatile memory device according to the first embodiment.
FIG. 10 is a diagram illustrating the number of reads for WL(n), the number of reads for WL(n-1), the number of reads for WL(n+1), the number of reads for simultaneous selection of WL(n-1) and WL(n+1), and the number of AND operations executed in a comparative example, and the number of reads for WL(n), the number of reads for WL(n-1), the number of reads for WL(n+1), the number of reads for simultaneous selection of WL(n-1) and WL(n+1), and the number of AND operations executed in the nonvolatile memory device according to the first embodiment.
FIG. 11 is a diagram illustrating a total number of reads and a total number of AND operations executed in the comparative example, and a total number of reads and a total number of AND operations executed in the nonvolatile memory device according to the first embodiment.
FIG. 12 is a flowchart illustrating an example of a procedure for a read operation executed in the nonvolatile memory device according to the first embodiment.
FIG. 13 is a diagram illustrating a combination of states of two adjacent memory cells connected respectively to two adjacent word lines, which is determined by executing a read operation of simultaneously selecting two adjacent word lines twice in a nonvolatile memory device according to a second embodiment.
FIG. 14 is a diagram illustrating the number of reads for WL(n), the number of reads for WL(n-1), the number of reads for WL(n+1), the number of reads for simultaneous selection of WL(n-1) and WL(n+1), and the number of AND operations executed in a comparative example, and the number of reads for WL(n), the number of reads for WL(n-1), the number of reads for WL(n+1), the number of reads for simultaneous selection of WL(n-1) and WL(n+1), and the number of AND operations executed in the nonvolatile memory device according to the second embodiment.
FIG. 15 is a diagram illustrating a total number of reads and a total number of AND operations executed in the comparative example, and a total number of reads and a total number of AND operations executed in the nonvolatile memory device according to the second embodiment.
FIG. 16 is a flowchart illustrating an example of a procedure for a read operation executed in the nonvolatile memory device according to the second embodiment.
FIG. 17 is a block diagram illustrating an example of a read operation of selecting one of two adjacent word lines independently, which is executed in a nonvolatile memory device according to a third embodiment.
FIG. 18 is a diagram illustrating a combination of states of two adjacent memory cells connected respectively to two adjacent word lines, which is determined by a read operation of simultaneously selecting two adjacent word lines and the read operation of selecting one of two adjacent word lines independently in the nonvolatile memory device according to the third embodiment.
FIG. 19 is a diagram illustrating the number of reads for WL(n), the number of reads for WL(n-1), the number of reads for WL(n+1), the number of reads for simultaneous selection of WL(n-1) and WL(n+1), and the number of AND operations executed in a comparative example, and the number of reads for WL(n), the number of reads for WL(n-1), the number of reads for WL(n+1), the number of reads for simultaneous selection of WL(n-1) and WL(n+1), and the number of AND operations executed in the nonvolatile memory device according to the third embodiment.
FIG. 20 is a diagram illustrating a total number of reads and a total number of AND operations executed in the comparative example, and a total number of reads and a total number of AND operations executed in the nonvolatile memory device according to the third embodiment.
FIG. 21 is a flowchart illustrating an example of a procedure for a read operation executed in the nonvolatile memory device according to the third embodiment.
FIG. 22 is a diagram illustrating another example of a combination of states of two adjacent memory cells connected respectively to two adjacent word lines, which is determined by a read operation of simultaneously selecting two adjacent word lines and the read operation of selecting one of two adjacent word lines independently in the nonvolatile memory device according to the third embodiment.
FIG. 23 is a diagram illustrating another example of a combination of states of two adjacent memory cells connected respectively to two adjacent word lines, which is determined by executing a read operation of simultaneously selecting two adjacent word lines twice in the nonvolatile memory device according to the second embodiment.

### DETAILED DESCRIPTION

Various embodiments will be described hereinafter with reference to the accompanying drawings.

An embodiment of the present invention provides a nonvolatile memory device and a control method thereof that can execute a read operation at high speed, which is capable of canceling cell-to-cell interference.

In general, according to one embodiment, a nonvolatile memory device includes: a plurality of memory cells connected in series, each of the plurality of memory cells being configured to store multiple bit data depending on which of a plurality of states with different threshold voltages the memory cell is in; a first bit line connected to the plurality of memory cells connected in series; a plurality of word lines connected respectively to the plurality of memory cells; and a control circuit configured to execute at least a read operation with respect to the plurality of memory cells. The control circuit executes a read operation of simultaneously selecting two adjacent word lines adjacent to a read target word line among the plurality of word lines by applying a first voltage to both the two adjacent word lines, the first voltage being a voltage for determining whether or not both threshold voltages of two adjacent memory cells connected respectively to the two adjacent word lines are threshold voltages of a first state or lower. The first state is a low-level state among the plurality of states, having a threshold voltage lower than or equal to a predetermined threshold voltage. The control circuit executes a first read operation of reading data from a read target memory cell connected to the read target word line by sequentially applying to the read target word line a plurality of different first read voltages that are determined based on assignment of data with respect to the plurality of states and 1-bit data to be read from the multiple bit data. The control circuit executes a second read operation of reading data from the read target memory cell by sequentially applying to the read target word line a plurality of second read voltages that are respectively lower than the plurality of first read voltages. The control circuit selects one of first data, which is data read from the read target memory cell in the first read operation, and second data, which is data read from the read target memory cell in the second read operation, based on read data of the first bit line detected by the read operation of simultaneously selecting the two adjacent word lines using the first voltage, and outputs the selected data as read data corresponding to the read target memory cell.

### (First Embodiment)

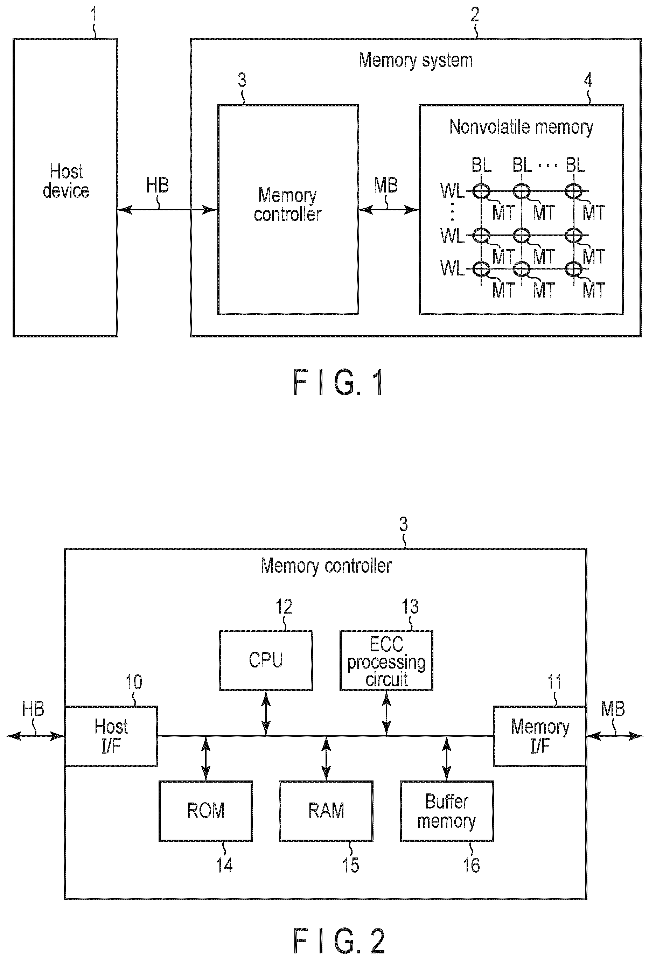

First, a configuration of a memory system 2 according to a first embodiment is described. FIG. 1 is a block diagram illustrating an example of the configuration of the memory system 2 according to the first embodiment. As shown in FIG. 1, the memory system 2 can be connected to an external host device 1 (also referred to as a host). The host device 1 is a computing device such as a server, a personal computer, or a mobile information terminal. The memory system 2 is a storage device such as a solid state drive (SSD) or a memory card. The memory system 2 includes, for example, a memory controller 3 and a nonvolatile memory device 4. The nonvolatile memory device 4 may be, for example, a single NAND flash memory device chip, or multiple NAND flash memory device chips, or a device in which multiple NAND flash memory device chips are connected to a single or multiple interface chips. In the following, for the sake of simplicity, a case where the nonvolatile memory device 4 is a single NAND flash memory device chip will be described; however, the configuration of the nonvolatile memory device 4 is not limited to this example.

The memory controller 3 is a semiconductor integrated circuit configured as, for example, a system on a chip (SoC), an application specific integrated circuit (ASIC), or a field-programmable gate array (FPGA). The memory controller 3 has a function of managing and controlling the nonvolatile memory device 4. The memory controller 3 is connectable to the host device 1 via a host bus HB. The memory controller 3 is connected to the nonvolatile memory device 4 via a memory bus MB. The memory controller 3 can control the nonvolatile memory device 4 based on a request received from the host device 1. For example, the memory controller 3 controls the nonvolatile memory device 4 to cause the nonvolatile memory device 4 to execute read, write, and erase operations, etc.

The nonvolatile memory device 4 is, for example, a nonvolatile semiconductor memory device configured to store data in a nonvolatile manner. The nonvolatile memory device 4 is, for example, NAND flash memory. In NAND flash memory, the unit of data read operation and data write operation is referred to as a page. The nonvolatile memory device 4 includes a plurality of memory cell transistors MT, a plurality of bit lines BL, and a plurality of word lines WL. For example, each memory cell transistor MT is associated with one bit line BL and one word line WL. A column address is assigned to each bit line BL. A page address is assigned to each word line WL.

Next, a hardware configuration of the memory controller 3 is described. FIG. 2 is a block diagram illustrating an example of the hardware configuration of the memory controller 3 provided in the memory system 2 according to the first embodiment. As shown in FIG. 2, the memory controller 3 includes, for example, a host interface circuit (host I/F) 10, a memory interface circuit (memory I/F) 11, a central processing unit (CPU) 12, an error correction code (ECC) processing circuit 13, a read only memory (ROM) 14, a random access memory (RAM) 15, and a buffer memory 16. The host I/F 10, the memory I/F 11, the CPU 12, the ECC processing circuit 13, the ROM 14, the RAM 15, and the buffer memory 16 may be connected to an internal bus.

The host I/F 10 executes communication in accordance with an interface standard between the host device 1 and the memory controller 3. The host I/F 10 is connected to the host device 1 via the host bus HB. The host I/F 10 supports interface standards such as serial advanced technology attachment (SATA), serial attached SCSI (SAS), PCI express^{™} (PCIe^{™}), and NVM express^{™} (NVMe^{™}).

The memory I/F 11 executes communication in accordance with an interface standard between the memory controller 3 and the nonvolatile memory device 4. The memory I/F 11 is connected to the nonvolatile memory device 4 via the memory bus MB. The memory I/F 11 supports interface standards such as Toggle DDR and open NAND flash interface (ONFI).

The CPU 12 is a processor that controls the overall operation of the memory controller 3. The CPU 12 instructs the nonvolatile memory device 4 to perform data write operations via the memory I/F 11 in accordance with write requests received via the host I/F 10. The CPU 12 instructs the nonvolatile memory device 4 to perform data read operations via the memory I/F 11 in accordance with read requests received via the host I/F 10.

The ECC processing circuit 13 is a circuit that executes ECC processing. The ECC processing includes data encoding and decoding. The ECC processing circuit 13 encodes data to be written to the nonvolatile memory device 4 and adds ECC to the data to be written to the nonvolatile memory device 4. The ECC processing circuit 13 also decodes data which is read from the nonvolatile memory device 4 to perform error detection and error correction of the read data.

The ROM 14 stores programs such as firmware. The ROM 14 is, for example, an electrically erasable programmable read-only memory (EEPROMTM). The CPU 12 executes various processes by executing the firmware stored in the ROM 14, etc.

The RAM 15 is a volatile memory. The RAM 15 is used as a work area for the CPU 12. The RAM 15 is, for example, a static random access memory (SRAM) or a dynamic random access memory (DRAM).

The buffer memory 16 is, for example, a volatile memory. The buffer memory 16 temporarily stores data received via the host I/F 10 and data received via the memory I/F 11, etc. The buffer memory 16 is, for example, DRAM or SRAM. The buffer memory 16 may be implemented outside of the memory controller 3.

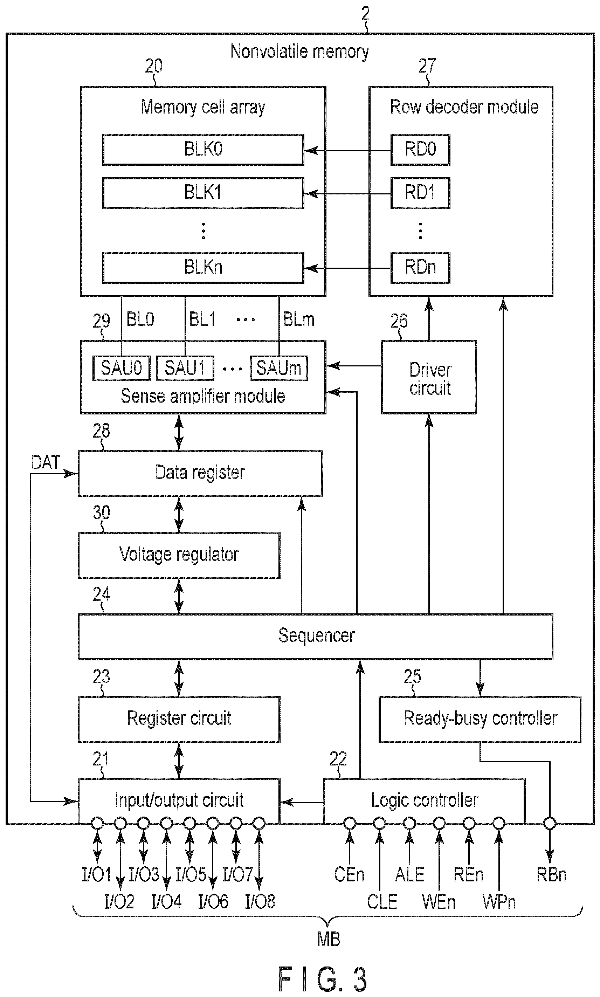

Next, a hardware configuration of the nonvolatile memory device 4 is described. FIG. 3 is a block diagram illustrating an example of the configuration of the nonvolatile memory device 4 provided in the memory system 2 according to the first embodiment. As shown in FIG. 3, the nonvolatile memory device 4 includes, for example, a memory cell array 20, an input/output circuit 21, a logic controller 22, a register circuit 23, a sequencer 24, a ready-busy controller 25, a driver circuit 26, a row decoder module 27, a data register 28, a sense amplifier module 29, and a voltage regulator 30. Signals transmitted and received via the memory bus MB include, for example, input/output signals I/O0 to I/O7, control signals CEn, CLE, ALE, WEn, REn, and WPn, and a ready-busy signal RBn.

The memory cell array 20 is a set of a plurality of memory cell transistors MT. The memory cell array 20 includes a plurality of blocks BLK0 to BLKn ("n" is an integer greater than or equal to 1). A block BLK is used, for example, as a unit of data erase operation. Each block BLK is assigned a block address. The memory cell array 20 is provided with a plurality of bit lines BL0 to BLm ("m" is an integer greater than or equal to 1) and a plurality of word lines WL (not shown).

The input/output circuit 21 controls transmission and reception (input/output) of the input/output signals I/O0 to I/O7. The input/output signals I/O can include data DAT, status information, addresses, and commands. The input/output circuit 21 can input and output data DAT between the data register 28 and the memory controller 3. The input/output circuit 21 can output the status information transferred from the register circuit 23, to the memory controller 3. The input/output circuit 21 can output each of the addresses and commands transferred from the memory controller 3, to the register circuit 23.

The logic controller 22 controls the input/output circuit 21 and the sequencer 24, based on various control signals input from the memory controller 3.

The logic controller 22 enables the nonvolatile memory device 4 based on the control signal CEn. The logic controller 22 notifies the input/output circuit 21 that the input/output signals I/O received by the nonvolatile memory device 4 are a command and an address, respectively, based on the control signals CLE and ALE. The logic controller 22 instructs the input/output circuit 21 to receive the input/output signals I/O based on the control signal WEn, and instructs the input/output circuit 21 to transmit the input/output signal I/O based on the control signal REn. The logic controller 22 puts the nonvolatile memory device 4 into a protected state based on the control signal WPn.

The register circuit 23 temporarily stores status, addresses, commands, etc. The status is information indicating an operating status of the nonvolatile memory device 4. The status is updated based on the control of the sequencer 24 and transferred to the memory controller 3 via the input/output circuit 21. The addresses can include block addresses, page addresses, column addresses, etc. The commands include instructions for various operations of the nonvolatile memory device 4.

The sequencer 24 is a control circuit that controls the overall operation of the nonvolatile memory device 4. The sequencer 24 executes read, write, and erase operations, etc., based on the commands and addresses stored in the register circuit 23. The sequencer 24 can also execute a read operation at high speed, which is capable of canceling cell-to-cell interference. The configuration for executing the read operation at high speed, which is capable of canceling cell-to-cell interference, is described later.

The ready-busy controller 25 generates the ready-busy signal RBn based on the control of the sequencer 24. The ready-busy signal RBn is a signal that notifies the memory controller 3 whether the nonvolatile memory device 4 is in a ready state or a busy state. The ready state is a state in which the nonvolatile memory device 4 can accept commands (instructions) from the memory controller 3, and is notified by a high-level ready-busy signal RBn. The busy state is a state in which the nonvolatile memory device 4 cannot accept commands (instructions) from the memory controller 3, and is notified by a low-level ready-busy signal RBn.

The driver circuit 26 generates voltages used in read, write, and erase operations, etc. The driver circuit 26 supplies the generated voltages to the row decoder module 27 and the sense amplifier module 29.

The row decoder module 27 is a circuit used to select blocks BLK and supply voltages to wiring such as word lines WL. The row decoder module 27 includes a plurality of row decoders RD0 to RDn. The row decoders RD0 to RDn are associated with blocks BLK0 to BLKn, respectively. Each row decoder RD can set the associated block BLK to be selected or unselected, based on the block address.

The data register 28 is a circuit that temporarily stores data DAT. The data register 28 is used, for example, to input and output data DAT between the input/output circuit 21 and the sense amplifier module 29. The data register 28 is also referred to as a data latch, page register, or cache memory.

The sense amplifier module 29 is a circuit used to supply voltage to each bit line BL and to read data. The sense amplifier module 29 includes a plurality of sense amplifier units SAU0 to SAUm. The sense amplifier units SAU0 to SAUm are associated with a plurality of bit lines BL0 to BLm, respectively. Each sense amplifier unit SAU can determine (detect) data read from a selected memory cell transistor MT, based on the voltage of the associated bit line BL.

The voltage regulator 30 has a function of determining a suitable shift value of a read voltage based on instructions of the sequencer 24 and the data DAT transferred from the data register 28.

Note that, in the nonvolatile memory device 4, a set of the memory cell array 20, the row decoder module 27, and the sense amplifier module 29 may be referred to as a plane. The plane includes at least the memory cell array 20. The nonvolatile memory device 4 may have multiple planes. The sequencer 24 can be configured to be able to control each of the multiple planes.

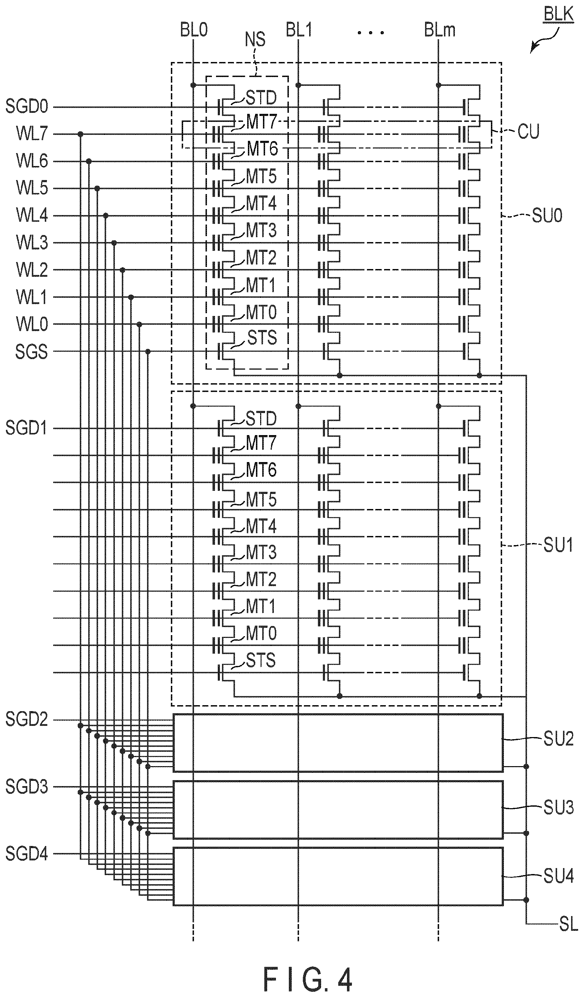

Next, a circuit configuration of the memory cell array 20 is described. FIG. 4 is a diagram illustrating an example of the circuit configuration of the memory cell array 20 according to the first embodiment. FIG. 4 shows one of the plurality of blocks BLK included in the memory cell array 20. As shown in FIG. 4, a block BLK includes a plurality of bit lines BL0 to BLm, a plurality of word lines WL0 to WL7, select gate lines SGDO to SGD4, a select gate line SGS, and a source line SL. Select gate lines SGDO to SGD4 and SGS and word lines WL0 to WL7 are provided for each block BLK. Bit lines BL0 to BLm are shared by a plurality of blocks BLK. The source line SL may be shared by a plurality of blocks BLK or provided for each block BLK.

The block BLK includes, for example, five string units SU0 to SU4. Each string unit SU includes a plurality of NAND strings NS. The plurality of NAND strings NS are associated with bit lines BL0 to BLm, respectively. That is, each bit line BL is shared by NAND strings NS that have the same column address assigned among a plurality of blocks BLK. Each NAND string NS is connected between the associated bit line BL and the source line SL.

Each NAND string NS includes, for example, directly connected memory cell transistors MT0 to MT7, as well as select transistors STD and STS. Each memory cell transistor MT is a memory cell with a control gate and a charge storage layer, and it holds (stores) data in a nonvolatile manner. A threshold voltage of the memory cell transistor MT can be changed based on the amount of charge injected into the charge storage layer, etc. The memory cell transistor MT stores data according to the threshold voltage. The select transistors STD and STS are used to select the string unit SU.

In each NAND string NS, the select transistor STD, the memory cell transistor MT7 to MT0, and the select transistor STS are connected in series in this order. Specifically, the drain of the select transistor STD is connected to the associated bit line BL. The source of the select transistor STD is connected to the drain of the memory cell transistor MT7. The drain of the select transistor STS is connected to the source of the memory cell transistor MT0. The source of the select transistor STS is connected to the source line SL. The memory cell transistors MT0 to MT7 are connected in series between the select transistors STD and STS.

The select gate lines SGDO to SGD4 are associated with the string units SU0 to SU4, respectively. Each select gate line SGD is connected to the gate of each of the plurality of select transistors STD included in the associated string unit SU. The select gate line SGS is connected to the gate of each of the plurality of select transistors STS included in the associated block BLK. The word lines WL0 to WL7 are connected respectively to the control gates of each of the plurality of memory cell transistors MT0 to MT7 included in the associated block BLK.

In the present specification, a set of a plurality of memory cell transistors MT commonly connected to a word line WL within a string unit SU is referred to as a cell unit CU. In the present specification, a set of 1-bit data stored in each of the plurality of memory cell transistors MT included in a cell unit CU is referred to as page data. A cell unit CU can store two or more page data depending on the number of bits of data stored in each memory cell transistor MT. That is, each memory cell transistor MT is configured to be set to one of a plurality of states with different threshold voltages and to store multiple bit data assigned to that state. In other words, each memory cell transistor MT is configured to be set to a threshold voltage corresponding to one of a plurality of states to which different multiple bit data are respectively assigned.

Note that the memory cell array 20 may have a circuit configuration other than the above. For example, the number of string units SU included in each block BLK and the number of memory cell transistors MT, select transistors STD, and select transistors STS included in each NAND string NS can be designed to be any number.

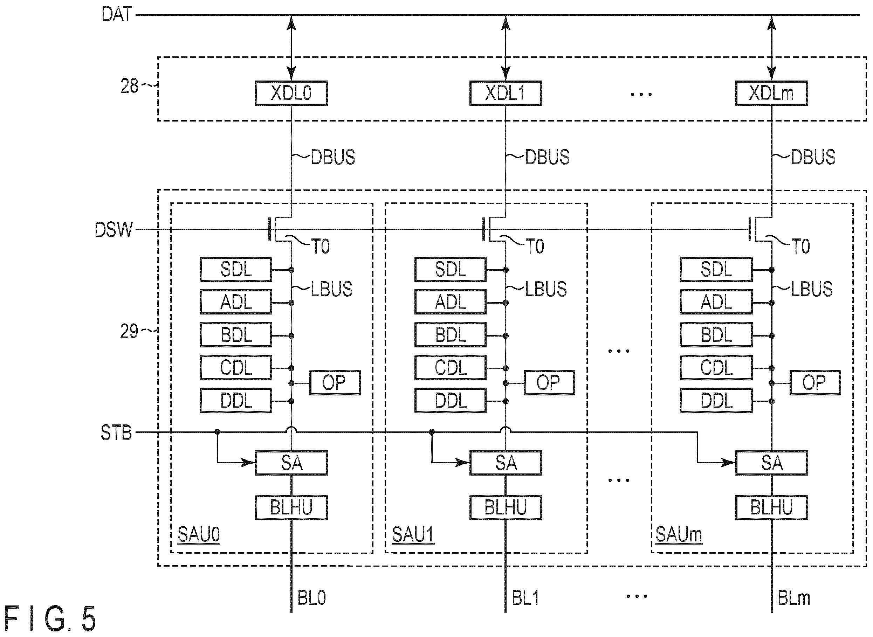

Next, circuit configurations of the sense amplifier module 29 and the data register 28 are described. FIG. 5 is a diagram illustrating an example of the circuit configurations of the sense amplifier module 29 and the data register 28 according to the first embodiment.

As shown in FIG. 5, each sense amplifier unit SAU includes, for example, a bit line connection BLHU, a sense amplifier SA, buses DBUS and LBUS, latch circuits SDL, ADL, BDL, CDL, and DDL, an operation unit OP, and a transistor T0. The data register 28 includes a plurality of latch circuits XDLO to XDLm. The latch circuits XDLO to XDLm are associated with the sense amplifier units SAU0 to SAUm, respectively. Each of the latch circuits XDLO to XDLm is connected to the associated sense amplifier unit SAU via the bus DBUS.

The bit line connection BLHU is, for example, a protection circuit that prevents a high voltage applied to a channel of the NAND string NS in an erase operation from being applied to the sense amplifier SA. The bit line connection BLHU may be configured to enable a predetermined voltage to be applied to an unselected bit line BL.

The sense amplifier SA is a circuit used to determine data based on the voltage of the bit line BL and to apply a voltage to the bit line BL. Each sense amplifier SA is connected to the associated bit line BL via the bit line connection BLHU. When a control signal STB is asserted during a read operation, the sense amplifier SA determines whether the data read from the selected memory cell transistor MT is "0" bit data or "1" bit data based on the voltage of the associated bit line BL. The control signal STB is generated, for example, by the sequencer 24.

Each of the latch circuits SDL, ADL, BDL, CDL, and DDL is capable of temporarily holding data. The latch circuits SDL, ADL, BDL, CDL, and DDL, as well as the sense amplifier SA, are configured to be capable of transmitting and receiving data via the bus LBUS.

The operation unit OP performs various logical operations using data stored in the latch circuits SDL, ADL, BDL, CDL, and DDL. Note that the sense amplifier unit SAU may also include a separate arithmetic circuit that performs various logical operations instead of the operation unit OP.

The transistor T0 of each sense amplifier unit SAU controls transfer of signals between the associated buses DBUS and LBUS. One end of the transistor T0 of each sense amplifier unit SAU is connected to the associated bus DBUS. The other end of the transistor T0 of each sense amplifier unit SAU is connected to the associated bus LBUS. The gate of the transistor T0 of each sense amplifier unit is input with a control signal DSW. The control signal DSW is generated, for example, by the sequencer 24.

Each latch circuit XDL is capable of temporarily holding data. Each latch circuit XDL is configured to be able to transmit and receive data with the associated sense amplifier unit SAU via the bus DBUS. Each latch circuit XDL is used for inputting and outputting data DAT between the sense amplifier module 29 and the input/output circuit 21. Each latch circuit XDL may be shared by a plurality of sense amplifier units SAU.

Note that the sense amplifier module 29 may have a circuit configuration other than the above. For example, the number of latch circuits provided in each sense amplifier unit SAU may be changed as appropriate. The operation unit OP may be omitted from the sense amplifier unit SAU.

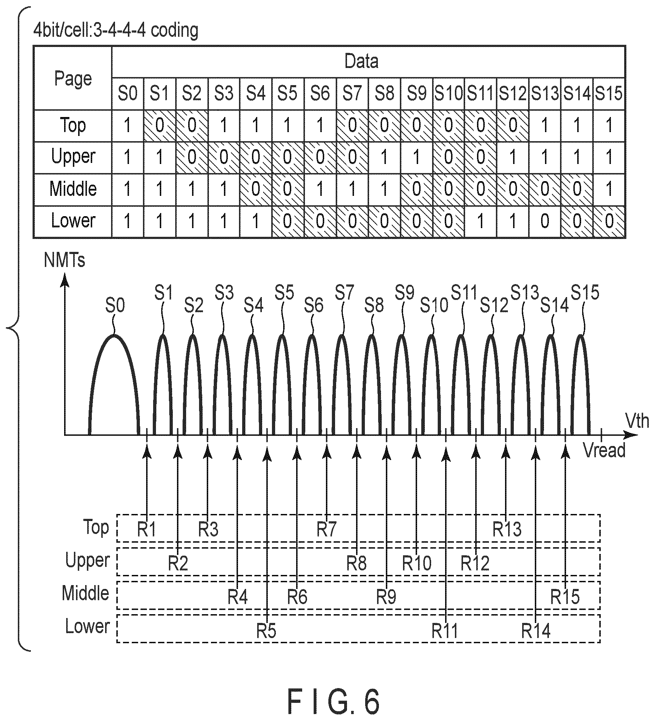

Next, threshold voltage distribution of the memory cell transistors MT is described. FIG. 6 is a diagram illustrating an example of the threshold voltage distributions of the memory cell transistors MT and the assignment of data in the memory system 2 according to the first embodiment. A vertical axis "NMTs" shows the number of memory cell transistors MT. A horizontal axis "Vth" shows the threshold voltage in relation to the memory cell transistors MT. As shown in FIG. 6, in a case where each memory cell transistor MT stores 4-bit data (in a case of 4-bit/cell), for example, the threshold voltage distributions of the plurality of memory cell transistors MT forms 16 states. Since data to be written to each cell unit CU is randomized, the memory cell transistors MT are distributed approximately evenly among the 16 states.

In the present specification, these 16 states are referred to as S0, S1, S2, S3, S4, S5, S6, S7, S8, S9, S10, S11, S12, S13, S14, and S15 states, in order from the lowest threshold voltage. Different 4-bit data are assigned to the memory cell transistors MT which respectively belong to the states S0 to S15,. Note that each memory cell transistor MT may store data of 2 bits, 3 bits, or 5 or more bits, and may be assigned data different from that described below. The operation described below may also be applied in a case where the memory cell transistor MT stores multiple bit data.

The following shows an example of assignment of data to the memory cell transistors MT respectively belonging to the 16 states. Note that the 4-bit data stored in each memory cell transistor MT is also referred to as top bit data, upper bit data, middle bit data, and lower bit data. In addition, four pages of data stored in the plurality of memory cell transistors MT included in each cell unit CU are also referred to as top page data, upper page data, middle page data, and lower page data. The top page data is a collection of top bit data portions respectively corresponding to the plurality of memory cell transistors MT included in each cell unit CU, the upper page data is a collection of upper bit data portions respectively corresponding to the plurality of memory cell transistors MT included in each cell unit CU, the middle page data is a collection of middle bit data portions respectively corresponding to the plurality of memory cell transistors MT included in each cell unit CU, and the lower page data is a collection of lower bit data portions corresponding to the plurality of memory cell transistors MT included in each cell unit CU. For example, 4-bit data is assigned to the 16 states as follows.

S0 state: "1111 (top bit data/upper bit data/middle bit data/lower bit data)" data
S1 state: "0111" data
S2 state: "0011" data
S3 state: "1011" data
S4 state: "1001" data
S5 state: "1000" data
S6 state: "1010" data
S7 state: "0010" data
S8 state: "0110" data
S9 state: "0100" data
S10 state: "0000" data
S11 state: "0001" data
S12 state: "0101" data
S13 state: "1101" data
S14 state: "1100" data
S15 state: "1110" data

A read voltage is set at each boundary between adjacent states. Specifically, read voltage R1 is set at the boundary between the S0 and S1 states. Read voltage R2 is set at the boundary between the S1 and S2 states. In the same manner, read voltages R3 to R15 are set at the boundaries between adjacent states. That is, read voltage Rj (where "j" is an integer between one and 15) is set at the boundary between S(j-1) state and Sj state. Furthermore, a read pass voltage Vread is set to a voltage higher than the state with the highest threshold voltage (e.g., S15 state).

The read voltage is applied to a read target word line WL. The read target word line WL is a word line WL selected as the read target, that is, the word line WL to which a set of read target memory cell transistors MT included in a read target cell unit CU is connected. Each of the read target memory cell transistors MT included in the cell unit CU of the read target word line WL, that is, each of the memory cell transistors connected to the read target word line WL, is turned on if the threshold voltage of the memory cell transistor is lower than the read voltage applied to the read target word line WL. The read pass voltage Vread is applied to each of the unselected word lines WL. Each of the memory cell transistors MT included in the cell unit CU of the word line WL to which the read pass voltage Vread is applied is turned on regardless of the data stored therein.

That is, the read operation for the read target word line WL is the operation of reading data from each of the read target memory cell transistors MT, and is executed by sequentially applying a plurality of read voltages that are mutually different to the read target word line WL. Here, the plurality of read voltages to be applied to the read target word line WL are determined based on the assignment of data to a plurality of states (e.g., S0 to S15 states in the case of a QLC-flash memory device) and 1-bit data to be read from multiple bit data (i.e., whether read target page data is lower page data, middle page data, upper page data, or top page data).

In a case where the data assignment shown in FIG. 6 is applied, when reading the lower page data from the plurality of read target memory cell transistors MT connected to the read target word line WL, the read operation of reading data from each of the plurality of memory cell transistors MT connected to the read target word line WL is executed by sequentially applying a plurality of read voltages (i.e., read voltages R5, R11, and R14) that are mutually different to the read target word line WL. Here, the read voltages R5, R11, and R14 are the plurality of read voltages predetermined for reading the lower page data. The read voltages R5, R11, and R14 are read voltages for distinguishing between the states S0 to S4, to which "1" is assigned, the states S5 to S10, to which "0" is assigned, the states S11 to S13, to which "1" is assigned, and the states S14 to S15, to which "0" is assigned. That is, the lower page data is determined by the read operation using the read voltages R5, R11, and R14.

When reading middle page data from the plurality of memory cell transistors MT connected to the read target word line WL, the read operation of reading data from each of the plurality of memory cell transistors MT connected to the read target word line WL is executed by sequentially applying a plurality of read voltages (i.e., read voltages R4, R6, R9, and R15) that are mutually different to the read target word line WL. Here, the read voltages R4, R6, R9, and R15 are the plurality of read voltages predetermined for reading the middle page data. The read voltages R4, R6, R9, and R15 are read voltages for distinguishing between the states S0 to S3, to which "1" is assigned, the states S4 to S5, to which "0" is assigned, the states S6 to S8, to which "1" is assigned, the states S9 to S14, to which "0" is assigned, and the state S15, to which "1" is assigned. That is, the middle page data is determined by the read operations using the read voltages R4, R6, R9, and R15.

When reading the upper page data from the plurality of memory cell transistors MT connected to the read target word line WL, the read operation of reading data from each of the plurality of memory cell transistors MT connected to the read target word line WL is executed by sequentially applying a plurality of read voltages (i.e., read voltages R2, R8, R10, and R12) that are mutually different to the read target word line WL. Here, the read voltages R2, R8, R10, and R12 are the plurality of read voltages predetermined for reading the upper page data. The read voltages R2, R8, R10, and R12 are read voltages for distinguishing between the states S0 to S1, to which "1" is assigned, the states S2 to S7, to which "0" is assigned, the states S8 to S9, to which "1" is assigned, the states S10 to S11, to which "0" is assigned, and the states S12 to S15, to which "1" is assigned. That is, the upper page data is determined by the read operations using the read voltages R2, R8, R10 and R12.

When reading the top page data from the plurality of memory cell transistors MT connected to the read target word line WL, the read operation of reading data from each of the plurality of memory cell transistors MT connected to the read target word line WL is executed by sequentially applying a plurality of read voltages (i.e., read voltages R1, R3, R7, and R13) that are mutually different to the read target word line WL. Here, the read voltages R1, R3, R7, and R13 are the plurality of read voltages predetermined for reading the top page data. The read voltages R1, R3, R7, and R13 are read voltages for distinguishing between the state S0, to which "1" is assigned, the states S1 to S2, to which "0" is assigned, the states S3 to S6, to which "1" is assigned, the states S7 to S12, to which "0" is assigned, and the states S13 to S15, to which "1" is assigned. That is, the top page data is determined by the read operation using the read voltages R1, R3, R7, and R13.

In the read operation for the read target word line WL using a plurality of read voltages, various operations are appropriately executed for each bit line BL in the sense amplifier unit SAU.

In other words, the read operation for the read target word line WL includes (1) an operation of sequentially applying a plurality of different read voltages to the read target word line WL, and (2) an operation of executing a logical operation (e.g., a logical operation such as an exclusive OR (XOR) or an exclusive NOT-OR (XNOR)) on a plurality of 1-bit data corresponding to the plurality of read voltages read from each of the read target memory cells connected to the read target word line WL, and determining the value ("1" or "0") of the 1-bit data read from each of the read target memory cells.

Note that the data assignment shown in FIG. 6 is also referred to as 3-4-4-4 coding, as the lower page data, the middle page data, the upper page data, and the top page data are determined by read operations using three read voltages, four read voltages, four read voltages, and four read voltages, respectively.

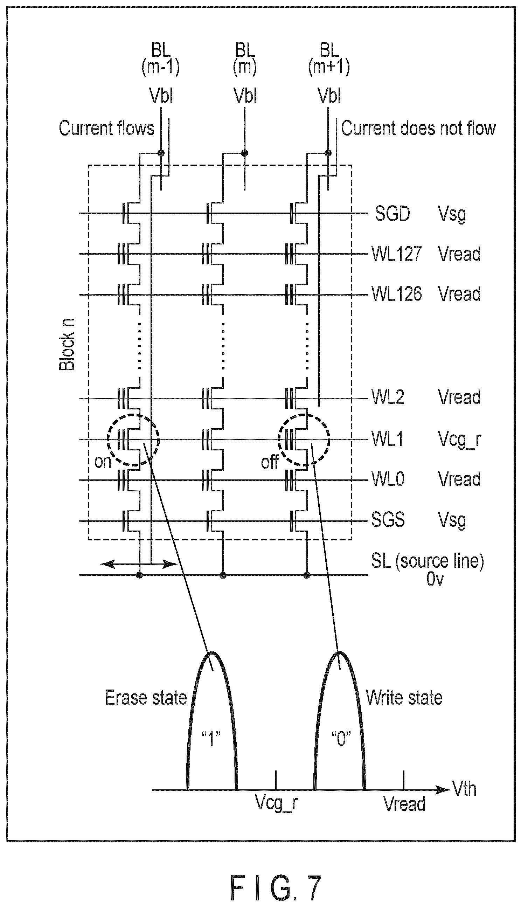

Next, an example of the read operation is described. FIG. 7 is a block diagram illustrating an example of the read operation for reading data from the nonvolatile memory device 4 according to the first embodiment. For the sake of simplicity, FIG. 7 shows a case where the nonvolatile memory device 4 is a single-level cell (SLC) flash memory device as an example. In an SLC-flash memory device, a threshold voltage value Vth of each memory cell transistor is set to one of two threshold voltages respectively corresponding to two states, including an erase state and a write state. The threshold voltage corresponding to the write state is higher than the threshold voltage value Vth corresponding to the erase state. In order to be able to determine whether the state of each memory cell transistor is an erase state or a write state, a read voltage Vcg_r, which is a voltage between the erase state and the write state, is applied to the read target word line WL. For example, in a case where the read target word line WL is word line WL1, the read voltage Vcg_r is applied to word line WL1. The read pass voltage Vread is applied to each of the other word lines WL0, WL2, ..., WL126, and WL127, excluding word line WL1.

All bit lines (here, bit line BL(m-1), bit line BL(m), and bit line BL(m+1)) are raised to voltage Vbl by the sense amplifier module 29.

For example, when assuming a case where the memory cell transistor associated with bit line BL(m-1) and word line WL1 is in an erase state, a read voltage Vcg_r that is higher than the threshold voltage of this memory cell transistor is applied to the control gate of this memory cell transistor. As a result, this memory cell transistor is turned on. Since the read pass voltage Vread is applied to the control gates of all other memory cell transistors associated with bit line BL(m-1), these memory cell transistors are turned on regardless of their threshold voltages. Therefore, since a current flows in bit line BL(m-1), for example, "1" is detected as the read data of the memory cell transistor (read target memory cell transistor) associated with bit line BL(m-1) and word line WL1.

Also, for example, when assuming a case where the memory cell transistor associated with bit line BL(m+1) and word line WL1 is in a write state, the read voltage Vcg_r applied to the control gate of this memory cell transistor is lower than the threshold voltage of this memory cell transistor. As a result, this memory cell transistor is turned off, and no current flows through bit line BL(m+1). Therefore, for example, "0" is detected as the read data of the memory cell transistor (read target memory cell transistor) associated with bit line BL(m+1) and word line WL1.

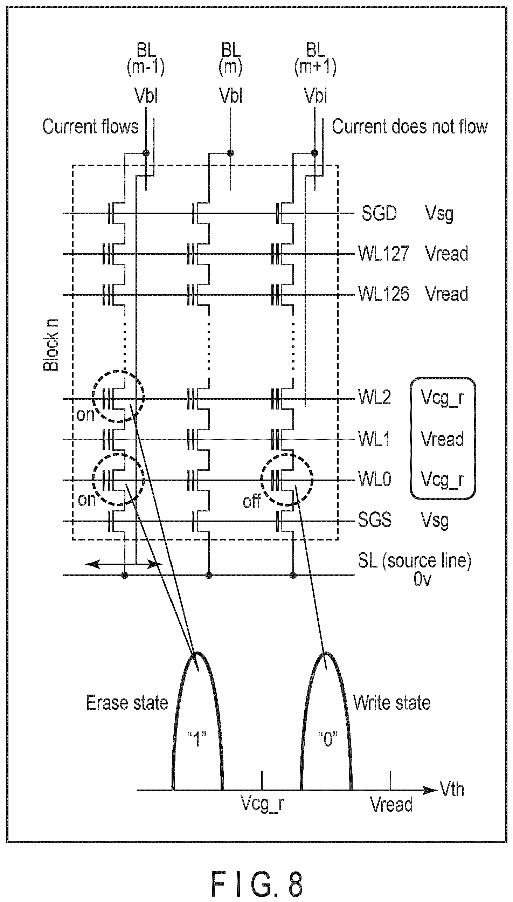

Next, a method for executing a read operation at high speed, which is capable of canceling cell-to-cell interference, is described. In the first embodiment, in order to enable a read operation capable of canceling cell-to-cell interference to be executed at high speed, a read operation of simultaneously selecting two adjacent word lines is used. FIG. 8 is a block diagram illustrating an example of the read operation of simultaneously selecting two adjacent word lines, which is executed in the nonvolatile memory device 4 according to the first embodiment. In FIG. 8, for the sake of simplicity, a case where the nonvolatile memory device 4 is an SLC-flash memory device is shown as an example.

In a case where the read target word line WL is word line WL(n), the two adjacent word lines of the read target word line WL(n) are word lines WL(n-1) and WL(n+1). For example, in a case where the read target word line WL is word line WL1, word lines WL0 and WL2 are the two adjacent word lines of word line WL1.

In the nonvolatile memory device 4, cell-to-cell interference can occur, in which the threshold voltage of the memory cell transistor connected to the word line WL(n) is shifted in accordance with both threshold voltages of the memory cell transistor connected to the word line WL(n-1) and the memory cell transistor connected to the word line WL(n+1).

For example, with respect to bit line BL(m-1), in a case where the threshold voltages of both the memory cell transistor associated with bit line BL(m-1) and word line WL(n+1) (adjacent memory cell transistor) and the memory cell transistor associated with bit line BL(m-1) and word line WL(n-1) (adjacent memory cell transistor) are lower than a certain reference voltage, in some cases, the threshold voltage of the read target memory cell transistor associated with bit line BL(m-1) and word line WL(n) may be shifted to the low voltage side due to the influence of the low threshold voltages of the two adjacent memory cell transistors.

Therefore, in the first embodiment, a read operation is executed in which two adjacent word lines (i.e., WL(n+1) and WL(n-1)) are simultaneously selected in order to determine whether or not the threshold voltages of both of the two adjacent memory cell transistors are threshold voltages equal to or lower than a reference state (a first state). Here, the first state is a low-level state that has a threshold voltage equal to or lower than a predetermined threshold voltage among a plurality of states (e.g., S0 to S15 states in a QLC-flash memory device).

In a read operation of simultaneously selecting word lines WL(n+1) and WL(n-1), a read voltage (e.g., in an SLC-flash memory, a read voltage Vcg_r having a voltage value between the threshold voltage of the erase state and the threshold voltage of the write state) is applied simultaneously to word line WL(n+1) and word line WL(n-1) to determine whether or not both threshold voltages of the two adjacent memory cell transistors are threshold voltages equal to or lower than the first state, thereby executing read operations with respect to word line WL(n+1) and word line WL(n-1). That is, the read voltage is applied to both the word line WL(n+1) and the word line WL(n-1), thereby executing the read operations with respect to word line WL(n+1) and word line WL(n-1).

For example, in a case where the read target word line is word line WL1, the read voltage Vcg_r is applied to word lines WL2 and WL0 simultaneously, thereby executing the read operations with respect to word lines WL2 and WL0. That is, the read voltage Vcg_r is applied to both the word line WL2 and the word line WL0, thereby executing the read operations with respect to word lines WL2 and WL0. Note that the read pass voltage Vread is applied to each of the word lines WL1, ..., WL3, ..., WL126, and WL127 other than the word lines WL0 and WL2.

All of the bit lines (here, bit line BL(m-1), bit line BL(m), and bit line BL(m+1)) are raised to voltage Vbl by the sense amplifier module 29.

For example, when assuming a case where the adjacent memory cell transistor associated with bit line BL(m-1) and word line WL2 is in the erase state, and the adjacent memory cell transistor associated with bit line BL(m-1) and word line WL0 is also in the erase state, a read voltage Vcg_r that is higher than the threshold voltage of each of these adjacent memory cell transistors is applied to the control gates of these two adjacent memory cell transistors. As a result, each of these adjacent memory cell transistors is turned on. Since the read pass voltage Vread is applied to the control gates of all other memory cell transistors associated with bit line BL(m-1), these memory cell transistors are turned on regardless of their threshold voltages. Therefore, since a current flows through bit line BL(m-1), for example, "1" is detected as the read data of bit line BL(m-1).

Next, when assuming a case where, among the adjacent memory cell transistor associated with bit line BL(m+1) and word line WL2 and the adjacent memory cell transistor associated with bit line BL(m+1) and word line WL0, at least the adjacent memory cell transistor associated with bit line BL(m+1) and word line WL0 is in a write state, the adjacent memory cell transistor associated with bit line BL(m+1) and word line WL0 is kept turned off. As a result, no current flows through bit line BL(m+1). Therefore, for example, "0" is detected as the read data of bit line BL (m+1).

Now, a read operation in a comparative example is considered. The read operation in the comparative example selects one adjacent word line (WL(n-1)) among the two adjacent word lines (WL(n+1) and WL(n-1)), applies the read voltage Vcg_r only to the selected adjacent word line (WL(n-1)), and applies the read pass voltage Vread to each of all other word lines WL. Read data is then detected for each bit line BL. After this, the read operation in the comparative example selects the other adjacent word line (WL(n+1)) among the two adjacent word lines (WL(n+1) and WL(n-1)), applies the read voltage Vcg_r only to the selected adjacent word line (WL(n+1)), and applies the read pass voltage Vread to each of all other word lines WL. Read data is then detected for each bit line BL. The read operation of the comparative example determines whether or not the threshold voltages of both of the two adjacent memory cell transistors are threshold voltages equal to or lower than the low-level state by executing an AND operation between the data read by the read operation of selecting WL(n-1) and the data read by the read operation of selecting WL(n+1).

As shown above, the read operation of the comparative example requires (1) a read operation for WL(n-1), (2) a read operation for WL(n+1), and (3) an AND operation between the result of the read operation in (1) and the result of the read operation in (2).

In the first embodiment, by executing a read operation of simultaneously selecting two adjacent word lines (WL(n+1) and WL(n-1)), it is possible to determine whether or not the threshold voltages of both of the two adjacent memory cell transistors are threshold voltages equal to or lower than the low-level state at high speed, using only a single read operation of simultaneously selecting two adjacent word lines (WL(n+1) and WL(n-1)). As a result, it is possible to execute a read operation at high speed, which is capable of canceling cell-to-cell interference, as compared with the case where the read operation of the comparative example is used.

Next, the read operation capable of canceling cell-to-cell interference, which is executed in the nonvolatile memory device 4 according to the first embodiment, is described. In the following, the read operation capable of canceling cell-to-cell interference is described by focusing on one of the plurality of bit lines, bit line BL(m-1), but in the read operation capable of canceling cell-to-cell interference, the same operation as that for bit line BL(m-1) is also executed for each of the other bit lines BL.

The memory controller 3 instructs the nonvolatile memory device 4 to execute the read operation capable of canceling cell-to-cell interference by, for example, transmitting to the nonvolatile memory device 4 a read command sequence in which a normal read command set (read command + address) follows a predetermined prefix command.

When the sequencer 24 of the nonvolatile memory device 4 receives this read command sequence, it executes a read operation of simultaneously selecting two adjacent word lines (word line WL(n-1) and word line WL(n+1)) adjacent to the read target word line WL(n) before executing a read operation for the read target word line WL(n).

In this case, the sequencer 24 applies a first voltage to both of the two adjacent word lines (word line WL(n-1) and word line WL(n+1)) to determine whether or not both threshold voltages of the two adjacent memory cell transistors (i.e., the memory cell transistor associated with bit line BL(m-1) and word line WL(n-1) and the memory cell transistor associated with bit line BL(m-1) and word line WL(n+1)) connected respectively to the two adjacent word lines are threshold voltages equal to or lower than a first state, which is a low-level state among a plurality of states (e.g., S0 to S15 states). In other words, the sequencer 24 applies the first voltage to the two adjacent word lines (word line WL(n-1) and word line WL(n+1)) simultaneously, thereby executing the read operation of simultaneously selecting the two adjacent word lines (word line WL(n-1) and word line WL(n+1)).

After executing the read operation in which two adjacent word lines (word line WL(n-1) and word line WL(n+1)) are simultaneously selected, the sequencer 24 sequentially applies to the read target word line WL(n) a plurality of first read voltages that are different from each other and are determined based on the assignment of data to a plurality of states (e.g., S0 to S15 states) and 1-bit data (e.g., any one of top/upper/middle/lower bit data) to be read from multiple bit data (e.g., 4-bit data), thereby executing a first read operation in which data is read from a read target memory cell transistor connected to the read target word line WL(n). Here, the read target memory cell transistor is a memory cell transistor associated with bit line BL(m-1) and word line WL(n).

For example, in a QLC-flash memory device to which 3-4-4-4 coding is applied, in the case of reading the top page data, that is, in the case of reading the top bit data of the 4-bit data stored in the memory cell transistor connected to the read target word line WL(n), the four read voltages R1, R3, R7 and R13 are sequentially applied to the read target word line WL(n). Hereinafter, these four read voltages will be referred to as "normal read voltages". These four read voltages are the same as those used in a case where the present invention is not applied, or are slightly higher (because the application of the present invention excludes slightly lower voltage components). The same applies to the three or four read voltages for the lower, middle, and upper pages other than the top page.

Next, the sequencer 24 executes a second read operation to read data from a read target memory cell by sequentially applying a plurality of second read voltages that are respectively lower than the plurality of first read voltages, to the read target word line WL(n). For example, in a QLC-flash memory device to which 3-4-4-4 coding is applied, in the case of reading the top page data, four read voltages that are respectively lower than the four read voltages R1, R3, R7, and R13 are used as the plurality of second read voltages.

Then, based on the read data ("1" or "0") of bit line BL(m-1) detected by the read operation of simultaneously selecting two adjacent word lines (word line WL(n-1) and word line WL(n+1)), the sequencer 24 selects one of the first data, which is the data read from the read target memory cell in the first read operation, and the second data, which is the data read from the read target memory cell in the second read operation, and outputs the selected data to the memory controller 3 as read data corresponding to the read target memory cell.

In this case, in a case where the value of the read data of bit line BL(m-1) detected by the read operation of simultaneously selecting two adjacent word lines (word line WL(n-1) and word line WL(n+1)) is a value ("1") corresponding to the case where both of the two adjacent memory cells are turned on, the sequencer 24 selects the second data as the read data corresponding to the read target memory cell.

On the other hand, in a case where the value of the read data of bit line BL(m-1) detected by the read operation of simultaneously selecting two adjacent word lines (word line WL(n-1) and word line WL(n+1)) is a value ("0") corresponding to the case where at least one of the two adjacent memory cells is turned off, the first data is selected as the read data corresponding to the read target memory cell.

As a result of the above operation, in a case where both threshold voltages of the two adjacent memory cells are threshold voltages equal to or lower than the low-level state, the data read at a read voltage lower than the normal read voltage can be output to the memory controller 3.

Next, a specific example of the read operation capable of canceling the cell-to-cell interference, which is executed in the nonvolatile memory device 4 according to the first embodiment, is described. In the following, a case in which the nonvolatile memory device 4 is realized as a QLC-flash memory device is assumed.

When a read command sequence in which a normal read command set follows a predetermined prefix command is received from the memory controller 3, the sequencer 24 of the nonvolatile memory device 4 simultaneously applies a voltage to the adjacent word line WL(n-1) and the adjacent word line WL(n+1) to determine that "both adjacent memory cell transistors are in a low-level state" (hereinafter referred to as LL) and executes the read operation of simultaneously selecting two adjacent word lines (word line WL(n-1) and word line WL(n+1)). That is, the sequencer 24 applies a voltage to both the adjacent word line WL(n-1) and the adjacent word line WL(n+1) to determine that "both adjacent memory cell transistors are LL", and executes the read operation of simultaneously selecting the two adjacent word lines (word line WL(n-1) and word line WL(n+1)). The sequencer 24 then detects the read data using the sense amplifier module 29 and stores the detected data in, for example, the latch circuit SDL (hereinafter referred to as a data latch S).

Specifically, the sequencer 24 applies the read pass voltage Vread to each of the other word lines WL other than the two adjacent word lines WL(n+1) and WL(n-1) to turn on the memory cell transistors connected to each of the other word lines WL, and applies a voltage for determination to the adjacent word lines WL(n+1) and WL(n-1). For example, in a case where the S2 state or lower is set as the "low-level state" in a QLC flash memory device, a predetermined voltage close to the read voltage R3 corresponding to the S2 state (which may be the read voltage R3 itself, a voltage slightly higher than the read voltage R3, or a voltage slightly lower than the read voltage R3, but a predetermined value) is applied to determine, for each bit line BL, whether or not both the memory cell transistor of WL(n-1) and the memory cell transistor of WL(n+1) are in a state of the S2 state or lower (i.e., whether or not they are "LL"). When focusing on a certain bit line BL, in a case where both the memory cell transistor of WL(n-1) and the memory cell transistor of WL(n+1) are in a state of S2 or lower, for example, in a case where the memory cell transistor of WL(n-1) is in the S0 state and the memory cell transistor of WL(n+1) is in the S2 state, both the memory cell transistors of WL(n-1) and WL(n+1) will be turned on, causing current to flow through this bit line, and the read data for this bit line will be "1", indicating that it is "LL". On the other hand, in a case where at least one of the memory cell transistors of WL(n-1) and WL(n+1) is in a state of the S3 state or higher, for example, in a case where the memory cell transistor of WL(n-1) is in the S0 state but the memory cell transistor of WL(n+1) is in the S3 state, the memory cell transistor of WL(n-1) will be turned on, but the memory cell transistor of WL(n+1) will be turned off, causing this bit line to become a non-conductive state at WL(n+1). Since no current will flow in this bit line, the read data of this bit line becomes "0", indicating that it is "not LL".

Thereafter, the sequencer 24 reads two types of data from the cell unit CU of the read target word line WL(n) from which data is to be actually read, the two types of data being: data "data C (C: Center)" read in a case where the normal read voltage is applied to the read target word line WL(n); and data "data M (M: Minus)" read in a case where a read voltage slightly lower than a normal read threshold is applied to the read target word line WL(n).

For example, in a QLC-flash memory device that is coded to read the lower page data using read voltages R5, R11, and R14, the middle page data using read voltages R4, R6, R9, and R15, the upper page data using read voltages R2, R8, R10, and R12, and the top page data using read voltages R1, R3, R7, and R13, in the case of reading the top page data, (1) data C obtained by combining, by a logical operation such as XOR, four 1-bit data read using the four read voltages R1, R3, R7, and R13 and (2) data M obtained by combining, by a logical operation such as XOR, four 1-bit data read using voltages that are 1 DAC, 2 DAC, 4 DAC, and 6 DAC lower than the four read voltages R1, R3, R7, and R13, respectively (i.e., a voltage obtained by shifting the read voltage R1 in a negative direction by 1 DAC, a voltage obtained by shifting the read voltage R3 in a negative direction by 2 DAC, a voltage obtained by shifting the read voltage R7 in a negative direction by 4 DAC, and a voltage obtained by shifting the read voltage R13 in a negative direction by 6 DAC) are generated for each bit line BL. Note that, although a case has been described here in which the amount of voltage shift is represented by a digital analog converter (DAC) value, the amount of voltage shift may be represented by a voltage value instead of the DAC value.

When outputting data from the nonvolatile memory device 4, the sequencer 24 selects data M for bit lines whose data latch S has a value of "1", i.e., bit lines whose state combination of two adjacent memory cell transistors connected respectively to two adjacent word lines is LL, and selects data C for other bit lines (i.e., bit lines whose data latch S has a value of "0", i.e., bit lines whose state combination of two adjacent memory cell transistors connected respectively to two adjacent word lines is not LL).

In this manner, by selecting data C and data M for each bit line BL based on the results of the read operation of simultaneously selecting two adjacent word lines, for bit lines in which both of the two adjacent memory cell transistors are in a low state, data read using a read voltage that is corrected lower than the normal read voltage can be output, and for bit lines in which at least one of the two adjacent memory cell transistors is not in a low state, data read using the normal read voltage can be output. Note that, as explained above, the same read voltage as in the case where the present invention is not applied or a read voltage slightly higher than the case where the present invention is not applied can be used as the normal read voltage.

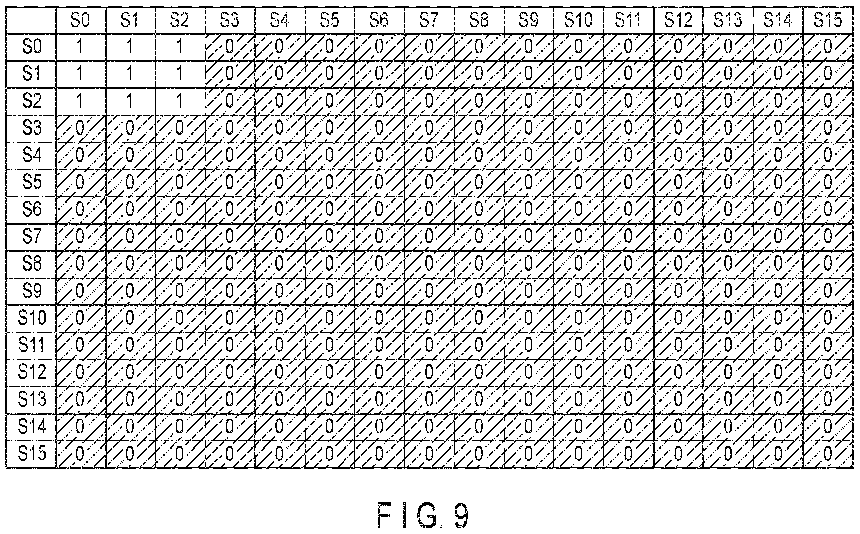

FIG. 9 is a diagram illustrating a combination of states of two adjacent memory cell transistors connected respectively to two adjacent word lines, which is determined by the read operation of simultaneously selecting two adjacent word lines in the nonvolatile memory device 4 according to the first embodiment.

In FIG. 9, S0 to S15 in a horizontal direction represent states of the memory cell transistors of the adjacent word line WL(n-1), and S0 to S15 in a vertical direction represent states of the memory cell transistors of the adjacent word line WL(n+1). Also, in FIG. 9, "1" indicates a combination of states of two adjacent memory cell transistors where data in the data latch S is "1", i.e., the combination of states of the two adjacent memory cell transistors corresponding to "LL", and "0" indicates a combination of states of two adjacent memory cell transistors where data in the data latch S is "0", i.e., the combination of states of the two adjacent memory cell transistors not corresponding to "LL". Furthermore, in FIG. 9, combination indicated by "0" is shaded.

In the read operation of the comparative example, in order to determine whether or not the combination of states of two adjacent memory cell transistors is "LL" as described in FIG. 9, (1) a read operation for WL(n-1), (2) a read operation for WL(n+1), and (3) an AND operation between the result of the read operation in (1) and the result of the read operation in (2) are required. In addition, the read operation of the comparative example also requires two read operations for WL(n) .

On the other hand, in the nonvolatile memory device 4 according to the first embodiment, it is possible to determine whether or not the combination of states of the two adjacent memory cell transistors is "LL" with only one read operation of simultaneously selecting two adjacent word lines (WL(n+1) and WL(n-1)). Thereafter, the nonvolatile memory device 4 according to the first embodiment requires two read operations for WL(n).

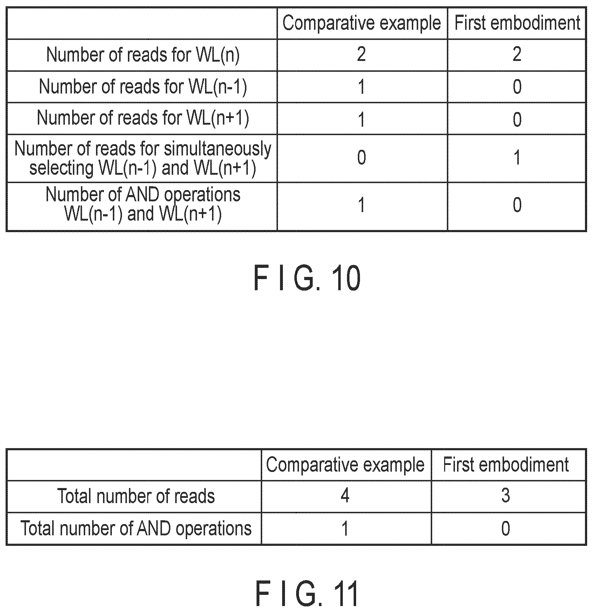

FIG. 10 is a diagram illustrating the number of reads for WL(n), the number of reads for WL(n-1), the number of reads for WL(n+1), the number of reads for simultaneous selection of WL(n-1) and WL(n+1), and the number of AND operations executed in the comparative example, and the number of reads for WL(n), the number of reads for WL(n-1), the number of reads for WL(n+1), the number of reads for simultaneous selection of WL(n-1) and WL(n+1), and the number of AND operations executed in the nonvolatile memory device 4 according to the first embodiment.

In the read operation of the comparative example, the number of reads for WL(n) is 2, the number of reads for WL(n-1) is 1, the number of reads for WL(n+1) is 1, the number of reads for simultaneous selection of WL(n-1) and WL(n+1) is 0, and the number of AND operations is 1.

On the other hand, in the nonvolatile memory device 4 according to the first embodiment, the number of reads for WL(n) is 2, the number of reads for WL(n-1) is 0, the number of reads for WL(n+1) is 0, the number of reads for simultaneous selection of WL(n-1) and WL(n+1) is 1, and the number of AND operations is 0.

FIG. 11 is a diagram illustrating a total number of reads and a total number of AND operations executed in the comparative example, and a total number of reads and a total number of AND operations executed in the nonvolatile memory device 4 according to the first embodiment.

In the read operation of the comparative example, the total number of reads executed to cancel cell-to-cell interference is 4, and the total number of AND operations executed to cancel cell-to-cell interference is 1.

On the other hand, in the nonvolatile memory device 4 according to the first embodiment, the total number of reads executed to cancel cell-to-cell interference is 3, and the total number of AND operations executed to cancel cell-to-cell interference is 0.

Therefore, in the nonvolatile memory device 4 according to the first embodiment, read operations capable of canceling cell-to-cell interference can be executed at high speed.

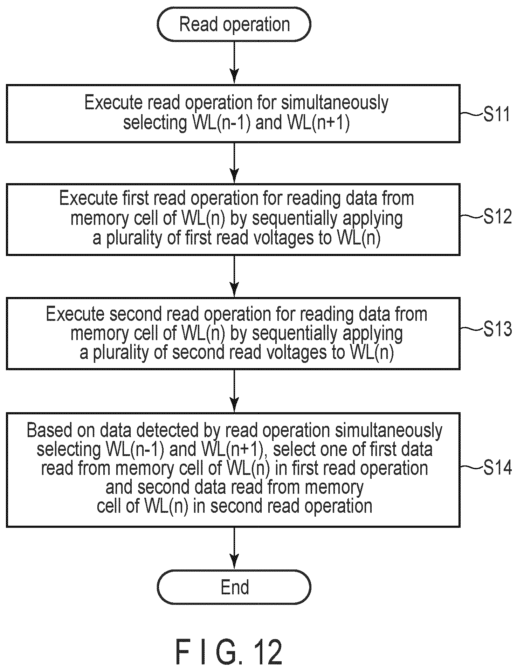

Next, a procedure for the read operation is described. FIG. 12 is a flowchart illustrating an example of the procedure for the read operation executed in the nonvolatile memory device 4 according to the first embodiment.

The sequencer 24 applies a first voltage to both WL(n-1) and WL(n+1) to determine whether or not both threshold voltages of the two adjacent memory cells connected respectively to WL(n-1) and WL(n+1) are threshold voltages equal to or lower than a first state which is a low-level state among a plurality of states. That is, the sequencer 24 simultaneously applies the first voltage to WL(n-1) and WL(n+1) to execute a read operation of simultaneously selecting WL(n-1) and WL(n+1) (step S11).

The sequencer 24 sequentially applies to WL(n) a plurality of different first read voltages that are determined based on the assignment of data to a plurality of states (in the QLC-flash memory device, states S0 to S15) and 1-bit data to be read from multiple bit data (in the QLC-flash memory device, one of lower bit data, middle bit data, upper bit data, and top bit data), thereby executing a first read operation that reads data from a read target memory cell transistor connected to WL(n) (step S12).

The sequencer 24 executes a second read operation that reads data from the read target memory cell transistor connected to WL(n) by sequentially applying a plurality of second read voltages that are respectively lower than the plurality of first read voltages, to WL(n) (step S13).

Then, the sequencer 24 selects one of the data between first data read from the read target memory cell transistor connected to WL(n) in the first read operation and second data read from the read target memory cell transistor connected to WL(n) in the second read operation based on the read data of the bit line BL detected by the read operation of simultaneously selecting WL(n-1) and WL(n+1), and outputs to the memory controller 3 the selected data as the read data of the read target memory cell transistor connected to WL(n) (step S14).

As described above, according to the nonvolatile memory device 4 of the first embodiment, it is possible to determine whether or not the combination of states of two adjacent memory cell transistors is "LL" by a single read operation of simultaneously selecting two adjacent word lines (WL(n+1) and WL(n-1)). Then, based on whether or not the combination of states of two adjacent memory cell transistors is "LL", one of the following data is selected as the read data of the read target memory cell transistor: the first data (data C) read by the first read operation in which a plurality of first read voltages are sequentially applied to the word line WL(n); or the second data (data M) read by the second read operation in which a plurality of second read voltages that are respectively higher than the plurality of first read voltages, are sequentially applied to the word line WL(n). Therefore, a read operation capable of canceling cell-to-cell interference can be executed at high speed.

Note that the read operation of the first embodiment is particularly effective in a QLC-flash memory device with 4-bits per cell or a nonvolatile memory device with 5 or more bits per cell, which adopts a two-step write operation such as a foggy fine write operation and a MLC fine write operation, the two-step write operation being an write operation that reduces cell-to-cell interference with the adjacent memory cell on the adjacent word line. In a QLC-flash memory device that uses a two-step write operation such as the foggy fine write operation, in order to reduce cell-to-cell interference from adjacent memory cells in WL(n+1) whose state is not yet fixed when WL(n) is written, a foggy write is performed to roughly set the state of WL(n+1) before a fine write is performed to fix the state of WL(n). For example, (1) a first-step write operation (foggy write operation) is executed for each memory cell transistor connected to WL(n-1) so that the threshold values of each memory cell transistor connected to WL(n-1) are set roughly, (2) then, the first-step write operation (foggy write operation) is executed for each memory cell transistor connected to WL(n) so that the threshold values of each memory cell transistor connected to WL(n) are set roughly, (3) after the first-step write operation (foggy write operation) for each memory cell transistor connected to WL(n) is completed, a second-step write operation (fine write operation) is executed for each memory cell transistor connected to WL(n-1) so that the threshold values of each memory cell transistor connected to WL(n-1) are finely set, (4) then, the first-step write operation (foggy write operation) is executed for each memory cell transistor connected to WL(n+1) so that the threshold values of each memory cell transistor connected to WL(n+1) are set roughly, and (5) after the first-step write operation (foggy write operation) for each memory cell transistor connected to WL(n+1) is completed, the second-step write operation (fine write operation) is executed for each memory cell transistor connected to WL(n) so that the threshold values of each memory cell transistor connected to WL(n) are finely set. Therefore, the threshold voltage of the memory cell transistor connected to WL(n) may be affected by both the threshold voltage of the memory cell transistor connected to WL(n-1) and the threshold voltage of the memory cell transistor connected to WL(n+1).

### (Second Embodiment)

A nonvolatile memory device according to a second embodiment not only executes a read operation to simultaneously select two adjacent word lines by applying a first voltage to both of the two adjacent word lines (i.e., applying the first voltage to the two adjacent word lines simultaneously) to determine whether or not both of two adjacent memory cell transistors have a threshold voltage equal to or lower than a first state, which is a low-level state among a plurality of states, but also executes an additional read operation to simultaneously select two adjacent word lines by applying a second voltage to both of the two adjacent word lines (i.e., applying the second voltage to the two adjacent word lines simultaneously) to determine whether or not both of two adjacent memory cell transistors have a threshold voltage equal to or lower than a second state. Here, the second state is a middle-level state among a plurality of states that have a threshold voltage higher than the threshold voltage of the first state.

This allows a threshold voltage combination of the two adjacent memory cell transistors to be evaluated with high precision based on a combination of read data of each bit line BL detected by a read operation of simultaneously selecting two adjacent word lines using the first voltage and read data of each bit line BL detected by a read operation of simultaneously selecting two adjacent word lines using the second voltage.

Note that, a hardware configuration of each of the nonvolatile memory device and a memory controller according to the second embodiment is the same as that of each of the nonvolatile memory device 4 and the memory controller 3 according to the first embodiment. Therefore, the description thereof is omitted here. Hereinafter, the nonvolatile memory device according to the second embodiment is described as a nonvolatile memory device 4.

Next, a read operation capable of canceling cell-to-cell interference, which is executed in the nonvolatile memory device 4 according to the first embodiment, is described. In the following, the read operation capable of canceling cell-to-cell interference is described by focusing on one of a plurality of bit lines, bit line BL(m-1), but in the read operation capable of canceling cell-to-cell interference, the same operation as that for bit line BL(m-1) is also executed for each of the other bit lines BL.

The memory controller 3 instructs the nonvolatile memory device 4 to execute the read operation capable of canceling cell-to-cell interference by, for example, transmitting to the nonvolatile memory device 4 a read command sequence in which a normal read command set (read command + address) follows a predetermined prefix command.

When a sequencer 24 of the nonvolatile memory device 4 receives this read command sequence, it executes a read operation of simultaneously selecting two adjacent word lines (word line WL(n-1) and word line WL(n+1)) adjacent to a read target word line WL(n) before executing a read operation for the read target word line WL(n).

In this case, the sequencer 24 applies a first voltage to both of the two adjacent word lines (word line WL(n-1) and word line WL(n+1)) to determine whether or not both threshold voltages of two adjacent memory cell transistors (i.e., a memory cell transistor associated with bit line BL(m-1) and word line WL(n-1) and a memory cell transistor associated with bit line BL(m-1) and word line WL(n+1)) connected respectively to the two adjacent word lines are threshold voltages equal to or lower than a first state, which is a low-level state among a plurality of states (e.g., S0 to S15 states). In other words, the sequencer 24 applies the first voltage to the two adjacent word lines (word line WL(n-1) and word line WL(n+1)) simultaneously, thereby executing the read operation of simultaneously selecting the two adjacent word lines (word line WL(n-1) and word line WL(n+1)).

After executing the read operation of simultaneously selecting two adjacent word lines (word line WL(n-1) and word line WL(n+1)) using the first voltage, the sequencer 24 applies to both of the two adjacent word lines (word line WL(n-1) and word line WL(n+1)) the second voltage for determining whether or not both threshold voltages of the two adjacent memory cell transistors are equal to or lower than the threshold voltage of the second state which is the middle-level state among the plurality of states (e.g., S0 to S15 states). That is, the sequencer 24 applies the second voltage simultaneously to the two adjacent word lines (word line WL(n-1) and word line WL(n+1)) to execute an additional read operation of simultaneously selecting the two adjacent word lines (word line WL(n-1) and word line WL(n+1)).

After twice executing the read operation in which two adjacent word lines (word line WL(n-1) and word line WL(n+1)) are simultaneously selected, the sequencer 24 sequentially applies to the read target word line WL(n) a plurality of first read voltages that are different from each other and are determined based on the assignment of data to a plurality of states (e.g., S0 to S15 states) and 1-bit data (e.g., any one of top/upper/middle/lower bit data) to be read from multiple bit data (e.g., 4-bit data), thereby executing a first read operation in which data is read from a read target memory cell transistor connected to the read target word line WL(n). Here, the read target memory cell transistor is the memory cell transistor associated with bit line BL(m-1) and word line WL(n).

For example, in a QLC-flash memory to which 3-4-4-4 coding is applied, in the case of reading top page data, that is, in the case of reading the top bit data of the 4-bit data stored in the read target memory cell transistor connected to the read target word line WL(n), four read voltages R1, R3, R7, and R13 are sequentially applied to the read target word line WL(n) .

Then, the sequencer 24 executes a second read operation to read data from the read target memory cell by sequentially applying a plurality of second read voltages that are respectively lower than the plurality of first read voltages, to the read target word line WL(n). For example, in a QLC-flash memory device to which 3-4-4-4 coding is applied, in the case of reading the top page data, four read voltages that are respectively lower than the four read voltages R1, R3, R7, and R13 are used as the plurality of second read voltages.

Then, the sequencer 24 executes a third read operation to read data from the read target memory cell by sequentially applying a plurality of third read voltages that are respectively higher than the plurality of first read voltages, to the read target word line WL(n). For example, in a QLC-flash memory device to which 3-4-4-4 coding is applied, in the case of reading the top page data, four read voltages that are respectively higher than the four read voltages R1, R3, R7, and R13 are used as the plurality of third read voltages.

Then, based on a combination of the read data ("1" or "0") of the bit line BL(m-1) detected by the read operation of simultaneously selecting two adjacent word lines using the first voltage and the read data ("1" or "0") of the bit line BL(m-1) detected by the additional read operation of simultaneously selecting two adjacent word lines using the second voltage, the sequencer 24 selects one of the first data, which is data read from the read target memory cell in the first read operation, the second data, which is data read from the read target memory cell in the second read operation, and third data, which is data read from the read target memory cell in the third read operation, and outputs the selected data to the memory controller 3 as read data corresponding to the read target memory cell.

In this case, for example, in a case where the combination of these read data is "11", where the read data detected by the read operation of simultaneously selecting two adjacent word lines using the first voltage is MSB, and the read data detected by the additional read operation of simultaneously selecting two adjacent word lines using the second voltage is LSB, the sequencer 24 selects the second data as the read data corresponding to the read target memory cell. In addition, in a case where the combination of these read data is "01", the sequencer 24 selects the first data as the read data corresponding to the read target memory cell. In addition, in a case where the combination of these read data is "00", the sequencer 24 selects the third data as the read data corresponding to the read target memory cell.

Next, a specific example of a read operation capable of canceling cell-to-cell interference, which is executed in the nonvolatile memory device 4 according to the second embodiment, is described. In the following, a case in which the nonvolatile memory device 4 is realized as a QLC-flash memory is assumed.

When a read command sequence in which a normal read command set follows a predetermined prefix command is received from the memory controller 3, the sequencer 24 of the nonvolatile memory device 4 simultaneously applies a voltage to the adjacent word line WL(n-1) and the adjacent word line WL(n+1) to determine that "both adjacent memory cell transistors are in a low-level state" (LL), that is, applies a voltage for determining that "both of the adjacent memory cell transistors are in a low-level state" (LL) to both the adjacent word line WL(n-1) and the adjacent word line WL(n+1), and executes the read operation of simultaneously selecting two adjacent word lines (word line WL(n-1) and word line WL(n+1)). The sequencer 24 detects the read data using a sense amplifier module 29 and stores the detected data in, for example, a latch circuit SDL (hereinafter referred to as a data latch S).

Specifically, the sequencer 24 applies a read pass voltage Vread to each of the other word lines WL other than the two adjacent word lines WL(n+1) and WL(n-1) to turn on the memory cell transistors connected to each of the other word lines WL, and applies a voltage for determination to the adjacent word lines WL(n+1) and WL(n-1). For example, in a case where an S2 state or lower is set as a "low-level state" in the QLC-flash memory, a predetermined voltage close to the read voltage R3 corresponding to the S2 state (which may be the read voltage R3 itself, a voltage slightly higher than the read voltage R3, or a voltage slightly lower than the read voltage R3, but a predetermined value) is applied to determine, for each bit line BL, whether or not both the memory cell transistor of WL(n-1) and the memory cell transistor of WL(n+1) are in a state of the S2 state or lower ("LL"). When focusing on a certain bit line BL, in a case where both the memory cell transistor of WL(n-1) and the memory cell transistor of WL(n+1) are in a state of S2 or lower, for example, in a case where the memory cell transistor of WL(n-1) is in the S0 state and the memory cell transistor of WL(n+1) is in the S2 state, both the memory cell transistors of WL(n-1) and WL(n+1) will be turned on, causing current to flow through this bit line, and the read data for this bit line will be "1", indicating that it is "LL". This read data is then stored in the data latch S. On the other hand, in a case where at least one of the memory cell transistors of WL(n-1) and WL(n+1) is in a state of the S3 state or higher, for example, in a case where the memory cell transistor of WL(n-1) is in the S0 state but the memory cell transistor of WL(n+1) is in the S3 state, the memory cell transistor of WL(n-1) will be turned on, but the memory cell transistor of WL(n+1) will be turned off, causing this bit line to become a non-conductive state at WL(n+1). Since no current will flow, the read data for this bit line becomes "0", indicating that it is "not LL". This read data is then stored in the data latch S.

Next, the sequencer 24 simultaneously applies a voltage to the adjacent word lines WL(n-1) and WL(n+1) to determine that "both adjacent memory cell transistors are in a state of the middle-level state or lower" (hereafter referred to as MM), that is, applies a voltage to both the adjacent word lines WL(n-1) and WL(n+1) to determine that "both adjacent memory cell transistors are in the MM state", and executes an additional read operation of simultaneously selecting the two adjacent word lines (word line WL(n-1) and word line WL(n+1)). The sequencer 24 then detects the read data using the sense amplifier module 29 and stores the detected data in another latch circuit (hereinafter referred to as a data latch T) other than the latch circuit SDL.

Specifically, the sequencer 24 applies the read pass voltage Vread to each of the other word lines WL other than the two adjacent word lines WL(n+1) and WL(n-1) to turn on the memory cell transistors connected to each of the other word lines WL, and applies a voltage for determination to the adjacent word lines WL(n+1) and WL(n-1). For example, in a case where an S11 state or lower is set as a "state of the middle-level state or lower" in the QLC-flash memory, a predetermined voltage close to a read voltage R12 corresponding to the S11 state (which may be the read voltage R12 itself, a slightly higher voltage than the read voltage R12, or a slightly lower voltage than the read voltage R12, but a predetermined value) is applied to determine, for each bit line BL, whether or not both the memory cell transistor of WL(n-1) and the memory cell transistor of WL(n+1) are in a state of the S11 state or lower. When focusing on a certain bit line BL, in a case where both the memory cell transistor of WL(n-1) and the memory cell transistor of WL(n+1) are in a state of S11 or lower, for example, in a case where the memory cell transistor of WL(n-1) is in the S0 state and the memory cell transistor of WL(n+1) is in the S6 state, both the memory cell transistors of WL(n-1) and WL(n+1) will be turned on, causing current to flow through this bit line, and the read data for this bit line will be "1", indicating that it is "MM". This read data is stored in the data latch T. On the other hand, in a case where at least one of the memory cell transistors of WL(n-1) and WL(n+1) is in a state of the S12 state or higher, for example, in a case where the memory cell transistor of WL(n-1) is in the S0 state but the memory cell transistor of WL(n+1) is in the S12 state, the memory cell transistor of WL(n-1) will be turned on, but the memory cell transistor of WL(n+1) will be turned off, causing this bit line to become a non-conductive state at WL(n+1). Since no current will flow in this bit line, the read data for this bit line will be "0", indicating that it is "not MM". This read data will be stored in the data latch T.

Thereafter, the sequencer 24 reads three types of data from a cell unit CU of the read target word line WL(n) from which data is to be actually read, the three types of data being: data "data C (C: Center)" read in a case where a normal read voltage is applied to the read target word line WL(n); data "data M (M: Minus)" read in a case where a read voltage slightly lower than a normal read threshold is applied to the read target word line WL(n); and data "data P (P: Plus)" read in a case where a read voltage slightly higher than the normal read threshold is applied to the read target word line WL(n).

For example, in a QLC-flash memory that is coded to read lower page data using read voltages R5, R11, and R14, middle page data using read voltages R4, R6, R9, and R15, upper page data using read voltages R2, R8, R10, and R12, and top page data using read voltages R1, R3, R7, and R13, in the case of reading the top page data, (1) data C obtained by combining, by a logical operation such as XOR, four 1-bit data read using the four read voltages R1, R3, R7, and R13, (2) data M obtained by combining, by a logical operation such as XOR, four 1-bit data read using voltages that are 1 DAC, 2 DAC, 4 DAC, and 6 DAC lower than the four read voltages R1, R3, R7, and R13, respectively (i.e., a voltage obtained by shifting the read voltage R1 in a negative direction by 1 DAC, a voltage obtained by shifting the read voltage R3 in a negative direction by 2 DAC, a voltage obtained by shifting the read voltage R7 in a negative direction by 4 DAC, and a voltage obtained by shifting the read voltage R13 in a negative direction by 6 DAC), and (3) data P obtained by combining, by a logical operation such as XOR, four 1-bit data read using voltages that are 5 DAC, 4 DAC, 2 DAC, and 1 DAC higher than the four read voltages R1, R3, R7, and R13, respectively (i.e., a voltage obtained by shifting the read voltage R1 in a positive direction by 5 DAC, a voltage obtained by shifting the read voltage R3 in a positive direction by 4 DAC, a voltage obtained by shifting the read voltage R7 in a positive direction by 2 DAC, and a voltage obtained by shifting the read voltage R13 in a positive direction by 1 DAC) are generated for each bit line BL.

When outputting data from the nonvolatile memory device 4, the sequencer 24 determines for each bit line whether the 2-bit value, where 1-bit data stored in the data latch S indicating whether or not it is "LL" is MSB, and 1-bit data stored in the data latch T indicating whether or not it is "MM" is LSB, is "11", "01", or "00", and selects (1) data M for the bit lines where the 2-bit value is "11", (2) data C for the bit lines where the value is "01", and (3) data P for the bit lines where the value is "00".

In this manner, by selecting either data C, data M, or data P for each bit line BL based on the results of the read operation of simultaneously selecting two adjacent word lines using the first voltage and the results of the additional read operation of simultaneously selecting two adjacent word lines using the second voltage, which is higher than the first voltage, it is possible to output data read using a read voltage that is corrected lower with respect to the normal read voltage for bit lines where both of the two adjacent memory cell transistors are in a low state, output data read using the normal read voltage for bit lines where at least one of the two adjacent memory cell transistors is in a middle-level state, and output data read using a read voltage that is corrected higher with respect to the normal read voltage for bit lines where at least one of the two adjacent memory cell transistors is in a high state, which is higher than the middle-level state.

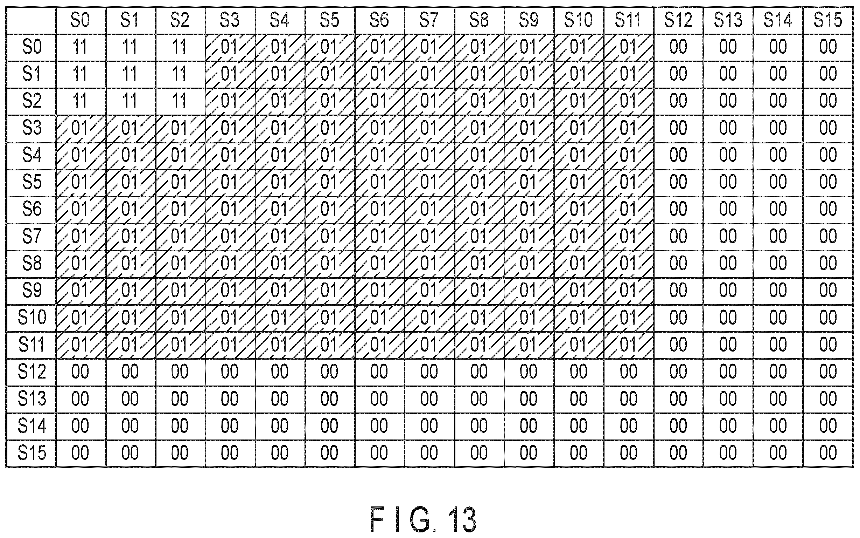

FIG. 13 is a diagram illustrating a combination of states of the two adjacent memory cell transistors connected respectively to two adjacent word lines, which is determined by executing a read operation of simultaneously selecting two adjacent word lines twice in the nonvolatile memory device 4 according to the second embodiment.

In FIG. 13, S0 to S15 in a horizontal direction represent states of the memory cell transistors of the adjacent word line WL(n-1), and S0 to S15 in a vertical direction represent states of the memory cell transistors of the adjacent word line WL(n+1).

In FIG. 13, "11" indicates a combination of states of two adjacent memory cell transistors where data of the data latch S is "1" (i.e., "LL") and data of the data latch T is "1" (i.e., "MM"). "01" indicates a combination of states of two adjacent memory cell transistors where the data of the data latch S is "0" (i.e., is not "LL") and the data of the data latch T is "1" (i.e., is "MM"). "00" indicates a combination of states of two adjacent memory cell transistors where the data of the data latch S is "0" (i.e., is not "LL") and the data of the data latch T is "0" (i.e., is not "MM"). In addition, in FIG. 13, the combination indicated by "01" is shaded.

In a read operation of a comparative example, adjacent word lines are selected one by one. Therefore, in order to determine whether the combination of states of the two adjacent memory cell transistors is "11", "01", or "00" by the read operation of the comparative example, (1) two read operations for WL(n-1), (2) two read operations for WL(n+1), and (3) two AND operations are required. The read operation of the comparative example also requires three read operations for WL(n).

On the other hand, in the nonvolatile memory device 4 according to the second embodiment, two read operations simultaneously selecting two adjacent word lines (WL(n+1) and WL(n-1)) can determine whether the combination of states of the two adjacent memory cell transistors is "11", "01", or "00". Thereafter, in the nonvolatile memory device 4 according to the second embodiment, three read operations for WL(n) are required.

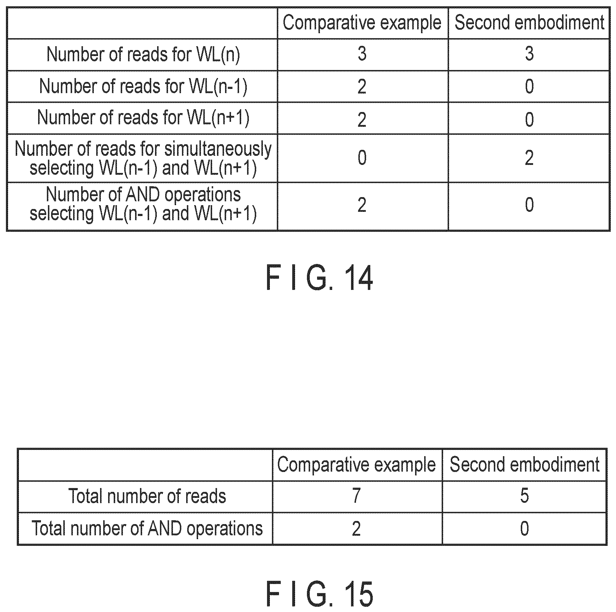

FIG. 14 is a diagram illustrating the number of reads for WL(n), the number of reads for WL(n-1), the number of reads for WL(n+1), the number of reads for simultaneous selection of WL(n-1) and WL(n+1), and the number of AND operations executed in the comparative example, and the number of reads for WL(n), the number of reads for WL(n-1), the number of reads for WL(n+1), the number of reads for simultaneous selection of WL(n-1) and WL(n+1), and the number of AND operations executed in the nonvolatile memory device 4 according to the second embodiment.

In the read operation of the comparative example, the number of reads for WL(n) is 3, the number of reads for WL(n-1) is 2, the number of reads for WL(n+1) is 2, the number of reads for simultaneous selection of WL(n-1) and WL(n+1) is 0, and the number of AND operations is 2.

On the other hand, in the nonvolatile memory device 4 according to the second embodiment, the number of reads for WL(n) is 3, the number of reads for WL(n-1) is 0, the number of reads for WL(n+1) is 0, the number of reads for simultaneous selection of WL(n-1) and WL(n+1) is 2, and the number of AND operations is 0.

FIG. 15 is a diagram illustrating a total number of reads and a total number of AND operations executed in the comparative example, and a total number of reads and a total number of AND operations executed in the nonvolatile memory device 4 according to the second embodiment.

In the read operation of the comparative example, the total number of reads executed to cancel cell-to-cell interference is 7 (= 3 + 2 + 2), and the total number of AND operations executed to cancel cell-to-cell interference is 2.

On the other hand, in the nonvolatile memory device 4 according to the second embodiment, the total number of reads executed to cancel cell-to-cell interference is 5 (= 3 + 2), and the total number of AND operations executed to cancel cell-to-cell interference is 0.

Therefore, in the nonvolatile memory device 4 according to the second embodiment, read operations capable of canceling cell-to-cell interference can be executed at high speed.

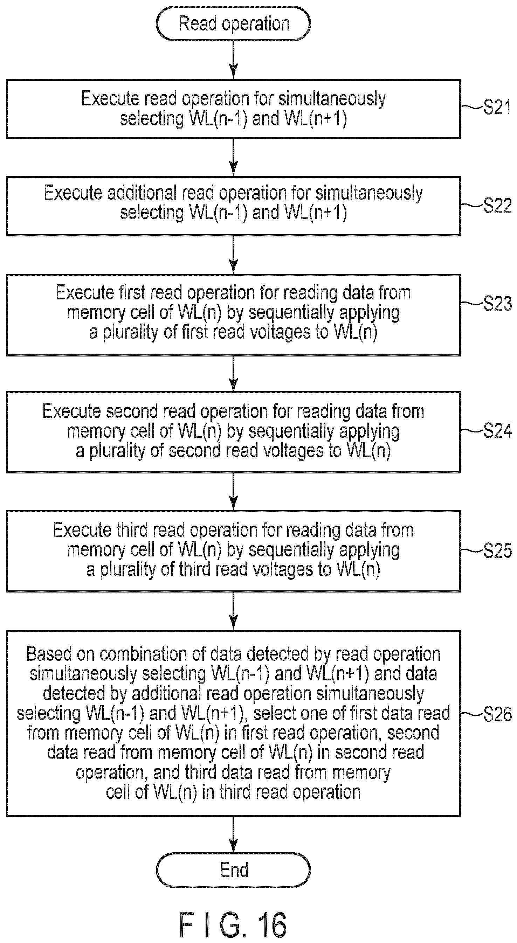

Next, a procedure for the read operation is described. FIG. 16 is a flowchart illustrating an example of the procedure for the read operation executed in the nonvolatile memory device 4 according to the second embodiment.

The sequencer 24 applies a first voltage to WL(n-1) and WL(n+1) simultaneously to determine whether or not both threshold voltages of two adjacent memory cells connected respectively to WL(n-1) and WL(n+1) are threshold voltages equal to or lower than a first state which is a low-level state among a plurality of states (i.e., "LL"). That is, the sequencer 24 applies the first voltage to both WL(n-1) and WL(n+1) to execute a read operation of simultaneously selecting WL(n-1) and WL(n+1) (step S21).

The sequencer 24 applies a second voltage to WL(n-1) and WL(n+1) simultaneously to determine whether or not both threshold voltages of two adjacent memory cells connected to WL(n-1) and WL(n+1) are threshold voltages equal to or lower than a second state which is a middle-level state among a plurality of states (i.e., "MM"). That is, the sequencer 24 applies the second voltage to both WL(n-1) and WL(n+1) to execute an additional read operation of simultaneously selecting WL(n-1) and WL(n+1) (step S22).

The sequencer 24 sequentially applies to WL(n) a plurality of different first read voltages that are determined based on the assignment of data to a plurality of states (in the QLC-flash memory, states S0 to S15) and 1-bit data to be read from multiple bit data (in the QLC-flash memory, one of lower bit data, middle bit data, upper bit data, and top bit data), thereby executing a first read operation that reads data C from a read target memory cell transistor connected to WL(n) (step S23).

The sequencer 24 executes a second read operation that reads data M from the read target memory cell transistor connected to WL(n) by sequentially applying a plurality of second read voltages that are respectively lower than the plurality of first read voltages, to WL(n) (step S24).

The sequencer 24 executes a third read operation that reads data P from the read target memory cell transistor connected to WL(n) by sequentially applying a plurality of third read voltages that are respectively higher than the plurality of first read voltages, to WL(n) (step S25).

Then, based on the combination of the read data of bit line BL detected by the read operation of simultaneously selecting WL(n-1) and WL(n+1) and the read data of bit line BL detected by the additional read operation of simultaneously selecting WL(n-1) and WL(n+1), the sequencer 24 selects one of the data among the first data read from the read target memory cell transistor connected to WL(n) in the first read operation, the second data read from the read target memory cell transistor connected to WL(n) in the second read operation, and the third data read from the read target memory cell transistor connected to WL(n) in the third read operation, and outputs the selected data as the read data of the read target memory cell transistor connected to WL(n) to the memory controller 3 (step S26).

As described above, according to the nonvolatile memory device 4 of the second embodiment, the combination of states (threshold voltages) of two adjacent memory cell transistors can be evaluated with high accuracy based on a combination of read data of each bit line BL detected by a read operation of simultaneously selecting two adjacent word lines using a first voltage and read data of each bit line BL detected by a read operation of simultaneously selecting two adjacent word lines using a second voltage. Then, based on the combination of the states of the two adjacent memory cell transistors, one of first data (data C), second data (data M), and third data (data P) is selected as the read data of the read target memory cell transistor. Therefore, it is possible to execute read operations that are capable of canceling cell-to-cell interference at high speed, and also to improve the accuracy of cell-to-cell interference correction.

### (Third Embodiment)

In a nonvolatile memory device according to a third embodiment, one of the two read operations that simultaneously selects two adjacent word lines (the read operation of simultaneously selecting two adjacent word lines using the first voltage corresponding to the low-level state, and the additional read operation of simultaneously selecting two adjacent word lines using the second voltage corresponding to the middle-level state) described in the second embodiment is changed to a read operation that independently selects only one of the two adjacent word lines.

In this case, the read operation of simultaneously selecting the two adjacent word lines using the first voltage corresponding to the low-level state may be changed to a read operation that independently selects only one of the adjacent word lines. Alternatively, the read operation of simultaneously selecting the two adjacent word lines using the second voltage corresponding to the middle-level state may be changed to a read operation that independently selects only one of the adjacent word lines.

Also, in the read operation that independently selects only one of the two adjacent word lines, only adjacent word line WL(n+1) may be selected independently, or only adjacent word line WL(n-1) may be selected independently.

Note that a hardware configuration of each of the nonvolatile memory device and a memory controller according to the third embodiment is the same as that of each of the nonvolatile memory device 4 and the memory controller 3 according to the first embodiment. Therefore, the description thereof is omitted here. Hereinafter, the nonvolatile memory device according to the third embodiment is described as a nonvolatile memory device 4.

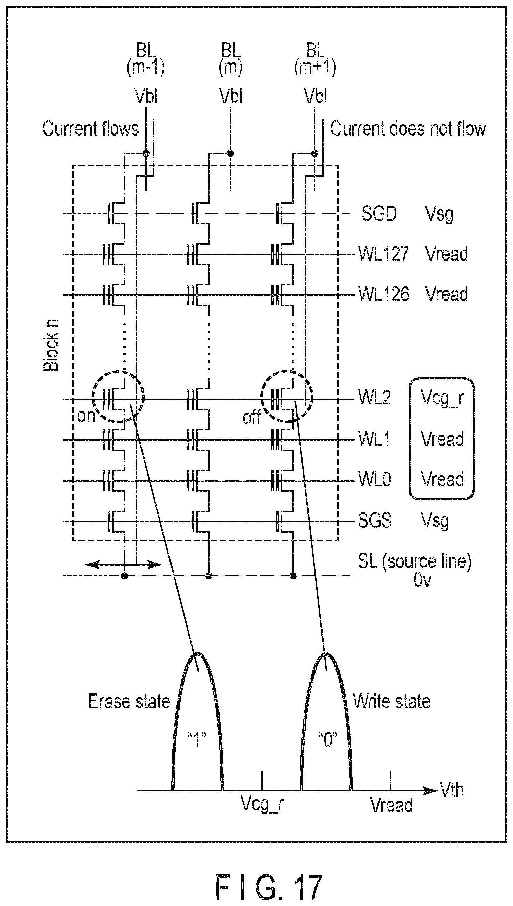

FIG. 17 is a block diagram illustrating an example of a read operation of selecting one of two adjacent word lines independently, which is executed in the nonvolatile memory device 4 according to the third embodiment.

FIG. 17 shows an example of a case in which, in one of two read operations of a read operation using the first voltage corresponding to the low-level state and a read operation using the second voltage corresponding to the middle-level state, only a threshold voltage of an adjacent memory cell transistor of the adjacent word line WL(n+1) of the two adjacent word lines (WL(n-1), WL(n+1)) is detected.

In this case, in one of the two read operations, which are the read operation using the first voltage corresponding to the low-level state and the read operation using the second voltage corresponding to the middle-level state, as shown in FIG. 17, a voltage corresponding to the state of a detection target is applied only to the adjacent word line WL(n+1) as a read voltage Vcg_r.

Note that, in the other read operation of the two read operations, which are the read operation using the first voltage and the read operation using the second voltage, a voltage corresponding to the state of a detection target is applied to both the adjacent word line WL(n-1) and the adjacent word line WL(n+1) as the read voltage Vcg_r, in the same manner as the read operation described in FIG. 8.

Next, a read operation capable of canceling cell-to-cell interference, which is executed in the nonvolatile memory device 4 according to the third embodiment is described. In the following, the read operation capable of canceling cell-to-cell interference is described by focusing on one of a plurality of bit lines, bit line BL(m-1), but in the read operation capable of canceling cell-to-cell interference, the same operation as that for bit line BL(m-1) is also executed for each of the other bit lines BL.

Also, in the following, an example of a case in which a read operation of simultaneously selecting two adjacent word lines using the second voltage corresponding to the middle-level state is changed to a read operation that only selects the adjacent word line WL(n+1) independently is described.

A memory controller 3 instructs the nonvolatile memory device 4 to execute the read operation capable of canceling cell-to-cell interference by, for example, transmitting to the nonvolatile memory device 4 a read command sequence in which a normal read command set (read command + address) follows a predetermined prefix command.

When a sequencer 24 of the nonvolatile memory device 4 receives this read command sequence, it executes a read operation of simultaneously selecting two adjacent word lines (word line WL(n-1) and word line WL(n+1)) adjacent to a read target word line WL(n) before executing a read operation for the word line WL(n).

In this case, the sequencer 24 applies the first voltage simultaneously to the two adjacent word lines (word line WL(n-1) and word line WL(n+1)) to determine whether or not both threshold voltages of two adjacent memory cell transistors (i.e., a memory cell transistor associated with bit line BL(m-1) and word line WL(n-1) and a memory cell transistor associated with bit line BL(m-1) and word line WL(n+1)) connected respectively to the two adjacent word lines are threshold voltages equal to or lower than a first state, which is a low-level state among a plurality of states (e.g., S0 to S15 states). In other words, the sequencer 24 applies the first voltage to both the two adjacent word lines (word line WL(n-1) and word line WL(n+1)), thereby executing the read operation of simultaneously selecting the two adjacent word lines (word line WL(n-1) and word line WL(n+1)).

After executing the read operation of simultaneously selecting two adjacent word lines (word line WL(n-1) and word line WL(n+1)) using the first voltage, the sequencer 24 applies the second voltage to the adjacent word line WL(n+1) to determine whether or not the threshold voltage of the adjacent memory cell transistor connected to the adjacent word line WL(n+1) is equal to or lower than a second state, which is a middle-level state among the plurality of states (e.g., S0 to S15 states), thereby executing the additional read operation for the adjacent word line WL(n+1).

Thereafter, the sequencer 24 sequentially applies to the read target word line WL(n) a plurality of different first read voltages that are determined based on assignment of data to a plurality of states (e.g., S0 to S15 states) and 1-bit data (e.g., one of top/upper/middle/lower bit data) to be read from multiple bit data (e.g., 4-bit data), thereby executing a first read operation that reads data from a read target memory cell transistor connected to the read target word line WL(n). Here, the read target memory cell transistor is a memory cell transistor associated with bit line BL(m-1) and word line WL(n).

For example, in a QLC-flash memory to which 3-4-4-4 coding is applied, in the case of reading top page data C, that is, in the case of reading top bit data C of the 4-bit data stored in the read target memory cell transistor connected to the read target word line WL(n), four read voltages R1, R3, R7, and R13 are sequentially applied to the read target word line WL(n) .

Next, the sequencer 24 executes a second read operation to read data M from a read target memory cell by sequentially applying a plurality of second read voltages that are respectively lower than the plurality of first read voltages, to the read target word line WL(n). For example, in a QLC-flash memory with to which 3-4-4-4 coding is applied, in the case of reading top page data M, four read voltages that are respectively lower than the four read voltages R1, R3, R7, and R13 are used as the plurality of second read voltages.

Next, the sequencer 24 executes a third read operation to read data P from a read target memory cell by sequentially applying a plurality of third read voltages that are respectively higher than the plurality of first read voltages, to the read target word line WL(n). For example, in a QLC-flash memory to which 3-4-4-4 coding is applied, in the case of reading top page data P, four read voltages that are respectively higher than the four read voltages R1, R3, R7, and R13 are used as the plurality of third read voltages.

Then, based on a combination of the read data ("1" or "0") of the bit line BL(m-1) detected by the read operation of simultaneously selecting two adjacent word lines using the first voltage and the read data ("1" or "0") of the bit line BL(m-1) detected by the additional read operation for the adjacent word line WL(n+1) using the second voltage, the sequencer 24 selects one of the first data, which is data read from the read target memory cell in the first read operation, the second data, which is data read from the read target memory cell in the second read operation, and third data, which is data read from the read target memory cell in the third read operation, and outputs the selected data to the memory controller 3 as read data corresponding to the read target memory cell.

In this case, for example, in a case where the combination of these read data is "11", where the read data detected by the read operation of simultaneously selecting two adjacent word lines using the first voltage (i.e., data that determines whether or not it is "LL") is MSB, and the read data detected by the additional read operation for the adjacent word line WL(n+1) using the second voltage (i.e., data that determines whether or not it is "MM") is LSB, the sequencer 24 selects the second data as the read data corresponding to the read target memory cell. In addition, in a case where the combination of these read data is "01", the sequencer 24 selects the first data as the read data corresponding to the read target memory cell. In addition, in a case where the combination of these read data is "00", the sequencer 24 selects the third data as the read data corresponding to the read target memory cell.

Next, a specific example of a read operation capable of canceling cell-to-cell interference, which is executed in the nonvolatile memory device 4 according to the third embodiment, is described. In the following, a case in which the nonvolatile memory device 4 is realized as a QLC-flash memory is assumed.

When a read command sequence in which a normal read command set follows a predetermined prefix command is received from the memory controller 3, the sequencer 24 of the nonvolatile memory device 4 simultaneously applies a voltage to the adjacent word line WL(n-1) and the adjacent word line WL(n+1) to determine that "both adjacent memory cell transistors are in a low-level state" ("LL"), that is, applies a voltage for determining that they are "LL" to both the adjacent word line WL(n-1) and the adjacent word line WL(n+1), and executes the read operation of simultaneously selecting two adjacent word lines (word line WL(n-1) and word line WL(n+1)). The sequencer 24 detects the read data using a sense amplifier module 29 and stores the detected data in a data latch S.

Specifically, the sequencer 24 applies a read pass voltage Vread to each of the other word lines WL other than the two adjacent word lines WL(n+1) and WL(n-1) to turn on the memory cell transistors connected to each of the other word lines WL, and applies a voltage for determination to the adjacent word lines WL(n+1) and WL(n-1). For example, in a case where an S2 state or lower is set as a "low-level state" in the QLC-flash memory, a predetermined voltage close to the read voltage R3 corresponding to the S2 state (which may be the read voltage R3 itself, a voltage slightly higher than the read voltage R3, or a voltage slightly lower than the read voltage R3, but a predetermined value) is applied to determine, for each bit line BL, whether or not both the memory cell transistor of WL(n-1) and the memory cell transistor of WL(n+1) are in a state of the S2 state or lower (i.e., "LL" or not). When focusing on a certain bit line BL, in a case where both the memory cell transistor of WL(n-1) and the memory cell transistor of WL(n+1) are in a state of S2 or lower, for example, in a case where the memory cell transistor of WL(n-1) is in the S0 state and the memory cell transistor of WL(n+1) is in the S2 state, both the memory cell transistors of WL(n-1) and WL(n+1) will be turned on, causing current to flow through this bit line, and the read data for this bit line will be "1", indicating that it is "LL". This read data is then stored in the data latch S. On the other hand, in a case where at least one of the memory cell transistors of WL(n-1) and WL(n+1) is in a state of the S3 state or higher, for example, in a case where the memory cell transistor of WL(n-1) is in the S0 state but the memory cell transistor of WL(n+1) is in the S3 state, the memory cell transistor of WL(n-1) will be turned on, but the memory cell transistor of WL(n+1) will be turned off, causing this bit line to become a non-conductive state at WL(n+1). Since no current will flow, the read data for this bit line becomes "0", i.e., indicating that it is "not LL". This read data is then stored in the data latch S.

Next, the sequencer 24 applies a voltage to one of the adjacent word lines WL(n-1) and WL(n+1) (here, adjacent word line WL(n+1)) to determine that "the adjacent memory cell transistor is in a state of the middle-level state or lower" (i.e., it is "MM"), and executes an additional read operation for the adjacent word line WL(n+1). The sequencer 24 then detects the read data by the sense amplifier module 29 and stores the detected data in a data latch T.

Specifically, the sequencer 24 applies the read pass voltage Vread to each of the other word lines WL other than the adjacent word line WL(n+1) to turn on the memory cell transistors connected to each of the other word lines WL, and applies a voltage for determination to the adjacent word line WL(n+1). For example, in a case where an S11 state or lower is set as a "state of the middle-level state or lower" in the QLC-flash memory, a predetermined voltage close to a read voltage R12 corresponding to the S11 state (which may be the read voltage R12 itself, a slightly higher voltage than the read voltage R12, or a slightly lower voltage than the read voltage R12, but a predetermined value) is applied to determine, for each bit line BL, whether or not the memory cell transistor of WL(n+1) is in a state of the S11 state or lower (i.e., whether or not it is "MM"). When focusing on a certain bit line BL, in a case where the memory cell transistor of WL(n+1) is in a state of S11 or lower, for example, in a case where the memory cell transistor of WL(n+1) is in the S6 state, the memory cell transistor of WL(n+1) will be turned on, causing current to flow through this bit line, indicating that it is "MM". This read data is stored in the data latch T. On the other hand, in a case where the memory cell transistor of WL(n+1) is in a state of the S12 state or higher, for example, in a case where the memory cell transistor of WL(n+1) is in the S12 state, the memory cell transistor of WL(n+1) will be turned off, causing this bit line to become a non-conductive state at WL(n+1). Since no current will flow in this bit line, the read data for this bit line will be "0", indicating that it is "not MM". This read data is stored in the data latch T.

Thereafter, the sequencer 24 reads three types of data from a cell unit CU of the read target word line WL(n) from which data is to be actually read, the three types of data being: data "data C (C: Center)" read in a case where a normal read voltage is applied to the read target word line WL(n); data "data M (M: Minus)" read in a case where a read voltage slightly lower than a normal read threshold is applied to the read target word line WL(n); and data "data P (P: Plus)" read in a case where a read voltage slightly higher than the normal read threshold is applied to the read target word line WL(n).

For example, in a QLC-flash memory that is coded to read lower page data using read voltages R5, R11, and R14, middle page data using read voltages R4, R6, R9, and R15, upper page data using read voltages R2, R8, R10, and R12, and top page data using read voltages R1, R3, R7, and R13, in the case of reading the top page data, (1) data C obtained by combining, by a logical operation such as XOR, four 1-bit data read using the four read voltages R1, R3, R7, and R13, (2) data M obtained by combining, by a logical operation such as XOR, four 1-bit data read using voltages that are 1 DAC, 2 DAC, 4 DAC, and 6 DAC lower than the four read voltages R1, R3, R7, and R13, respectively (i.e., a voltage obtained by shifting the read voltage R1 in a negative direction by 1 DAC, a voltage obtained by shifting the read voltage R3 in a negative direction by 2 DAC, a voltage obtained by shifting the read voltage R7 in a negative direction by 4 DAC, and a voltage obtained by shifting the read voltage R13 in a negative direction by 6 DAC), and (3) data P obtained by combining, by a logical operation such as XOR, four 1-bit data read using voltages that are 5 DAC, 4 DAC, 2 DAC, and 1 DAC higher than the four read voltages R1, R3, R7, and R13, respectively (i.e., a voltage obtained by shifting the read voltage R1 in a positive direction by 5 DAC, a voltage obtained by shifting the read voltage R3 in a positive direction by 4 DAC, a voltage obtained by shifting the read voltage R7 in a positive direction by 2 DAC, and a voltage obtained by shifting the read voltage R13 in a positive direction by 1 DAC) are generated for each bit line BL.

When outputting data from the nonvolatile memory device 4, the sequencer 24 (1) selects data M for the bit line in which 2-bit value is "11", where 1-bit data stored in the data latch S indicating whether or not it is "LL" is MSB of the 2-bit value, and 1-bit data stored in the data latch T indicating whether or not it is "MM" is LSB of the 2-bit value, (2) selects data C for the bit line in which the 2-bit value is "01, and (3) selects data P for the bit line in which the 2-bit value is "00".

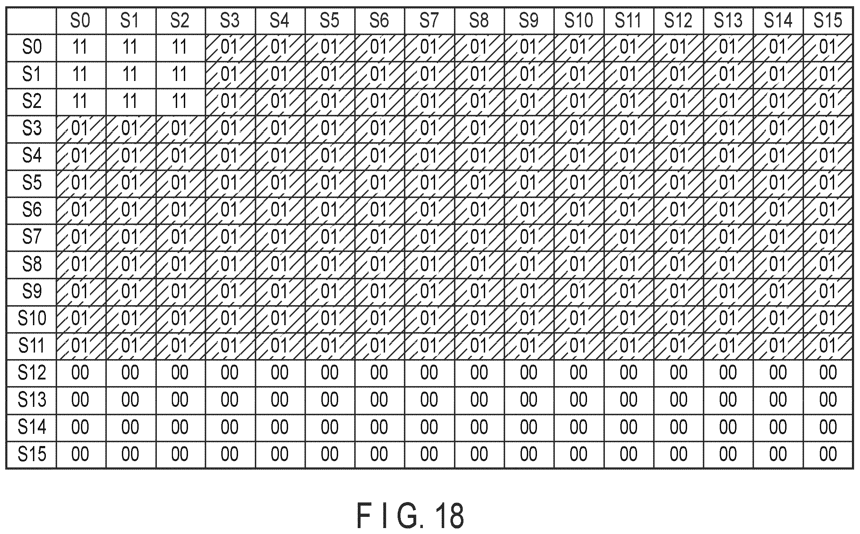

FIG. 18 is a diagram illustrating a combination of states of the two adjacent memory cell transistors connected respectively to two adjacent word lines, which is determined by the read operation of simultaneously selecting two adjacent word lines and the read operation that independently selects one of the two adjacent word lines in the nonvolatile memory device according to the third embodiment.

In FIG. 18, S0 to S15 in a horizontal direction represent states of the memory cell transistors of the adjacent word line WL(n-1), and S0 to S15 in a vertical direction represent states of the memory cell transistors of the adjacent word line WL(n+1).

In FIG. 18, "11" indicates a combination of states of two adjacent memory cell transistors where data of the data latch S is "1" (i.e., is "LL") and data of the data latch T is "1" (i.e., is "MM"). "01" indicates a combination of states of two adjacent memory cell transistors where the data of the data latch S is "0" (i.e., is not "LL") and the data of the data latch T is "1" (i.e., is "MM"). "00" indicates a combination of states of two adjacent memory cell transistors where the data of the data latch S is "0" (i.e., is not "LL") and the data of the data latch T is "0" (i.e., is not "MM"). In addition, in FIG. 18, the combination indicated by "01" is shaded.

In a read operation of a comparative example, adjacent word lines are selected one by one. Therefore, in order to determine whether the combination of states of the two adjacent memory cell transistors is "11", "01", or "00" by the read operation of the comparative example, (1) a single read operation for WL(n-1), (2) two read operations for WL(n+1), and (3) a single AND operation are required. The read operation of the comparative example also requires three read operations for WL(n).

On the other hand, in the nonvolatile memory device 4 according to the third embodiment, a single read operation simultaneously selecting two adjacent word lines (WL(n+1) and WL(n-1)) and a single read operation independently selecting WL(n+1) can determine whether the combination of states of the two adjacent memory cell transistors is "11", "01", or "00". Thereafter, in the nonvolatile memory device 4 according to the third embodiment, three read operations for WL(n) are required.

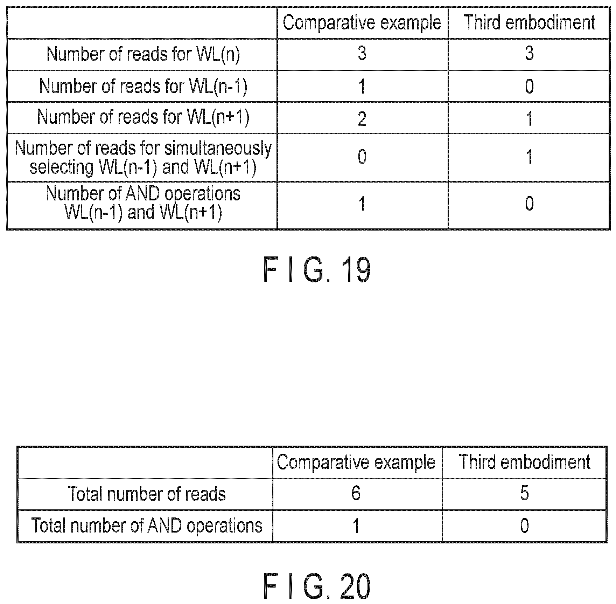

FIG. 19 is a diagram illustrating the number of reads for WL(n), the number of reads for WL(n-1), the number of reads for WL(n+1), the number of reads for simultaneous selection of WL(n-1) and WL(n+1), and the number of AND operations executed in the comparative example, and the number of reads for WL(n), the number of reads for WL(n-1), the number of reads for WL(n+1), the number of reads for simultaneous selection of WL(n-1) and WL(n+1), and the number of AND operations executed in the nonvolatile memory device 4 according to the third embodiment.

In the read operation of the comparative example, the number of reads for WL(n) is 3, the number of reads for WL(n-1) is 1, the number of reads for WL(n+1) is 2, the number of reads for simultaneous selection of WL(n-1) and WL(n+1) is 0, and the number of AND operations is 1.

On the other hand, in the nonvolatile memory device 4 according to the third embodiment, the number of reads for WL(n) is 3, the number of reads for WL(n-1) is 0, the number of reads for WL(n+1) is 1, the number of reads for simultaneous selection of WL(n-1) and WL(n+1) is 1, and the number of AND operations is 0.

FIG. 20 is a diagram illustrating a total number of reads and a total number of AND operations executed in the comparative example, and a total number of reads and a total number of AND operations executed in the nonvolatile memory device 4 according to the third embodiment.

In the read operation of the comparative example, the total number of reads executed to cancel cell-to-cell interference is 6 (= 3 + 1 + 2), and the total number of AND operations executed to cancel cell-to-cell interference is 1.

On the other hand, in the nonvolatile memory device 4 according to the third embodiment, the total number of reads executed to cancel cell-to-cell interference is 5 (= 3 + 1 + 1), and the total number of AND operations executed to cancel cell-to-cell interference is 0.

Therefore, in the nonvolatile memory device 4 according to the third embodiment, read operations capable of canceling cell-to-cell interference can be executed at high speed.

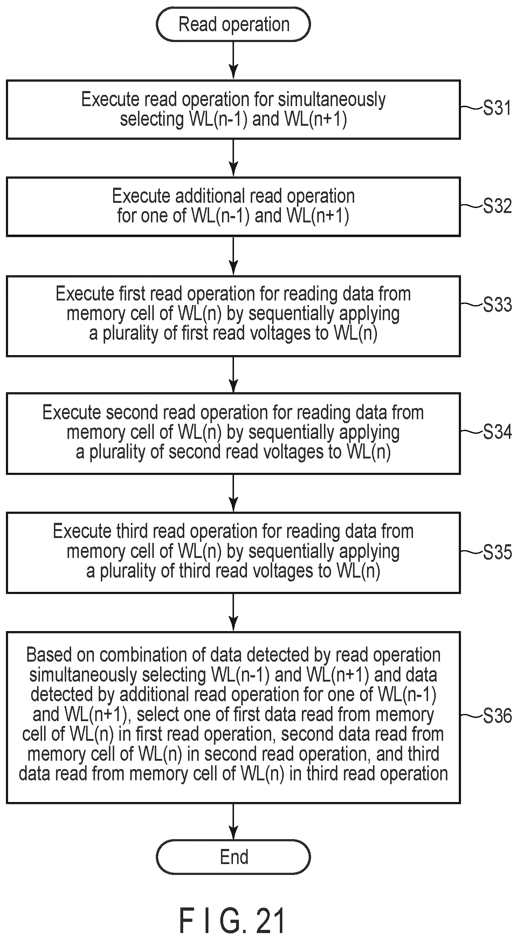

Next, a procedure for the read operation is described. FIG. 21 is a flowchart illustrating an example of the procedure for the read operation executed in the nonvolatile memory device 4 according to the third embodiment.

The sequencer 24 applies a first voltage to WL(n-1) and WL(n+1) simultaneously to determine whether or not both threshold voltages of two adjacent memory cells connected respectively to WL(n-1) and WL(n+1) are threshold voltages equal to or lower than a first state which is a low-level state among a plurality of states. That is, the sequencer 24 applies the first voltage to both WL(n-1) and WL(n+1) to execute a read operation of simultaneously selecting WL(n-1) and WL(n+1) (step S31).

The sequencer 24 applies a second voltage to one of WL(n-1) and WL(n+1) (e.g., WL(n+1)) to determine whether or not the threshold voltage of the adjacent memory cell connected to one of WL(n-1) and WL(n+1) (e.g., WL(n+1)) is a threshold voltage equal to or lower than a second state which is a middle-level state among a plurality of states, thereby executing an additional read operation for one of WL(n-1) and WL(n+1) (step S32).

The sequencer 24 sequentially applies to WL(n) a plurality of different first read voltages that are determined based on the assignment of data to a plurality of states (in the QLC-flash memory, states S0 to S15) and 1-bit data to be read from multiple bit data (in the QLC-flash memory, one of lower bit data, middle bit data, upper bit data, and top bit data), thereby executing a first read operation that reads data from a read target memory cell transistor connected to WL(n) (step S33).

The sequencer 24 executes a second read operation that reads data from the read target memory cell transistor connected to WL(n) by sequentially applying a plurality of second read voltages that are respectively lower than the plurality of first read voltages, to WL(n) (step S34).

The sequencer 24 executes a third read operation that reads data from the read target memory cell transistor connected to WL(n) by sequentially applying a plurality of third read voltages that are respectively higher than the plurality of first read voltages, to WL(n) (step S35).

Then, based on the combination of the read data of bit line BL detected by the read operation of simultaneously selecting WL(n-1) and WL(n+1) (the read operation in step S31) and the read data of bit line BL detected by the additional read operation that independently selects one of WL(n-1) and WL(n+1) (e.g., WL(n+1)) (the read operation in step S32), the sequencer 24 selects one of the data among the first data read from the read target memory cell transistor connected to WL(n) in the first read operation, the second data read from the read target memory cell transistor connected to WL(n) in the second read operation, and the third data read from the read target memory cell transistor connected to WL(n) in the third read operation, and outputs the selected data as the read data of the read target memory cell transistor connected to WL(n) to the memory controller 3 (step S36).

Through the above operations, the third embodiment also achieves the same effect as the second embodiment.

In addition, here, although a case in which the read operation of the second embodiment, which simultaneously selects two adjacent word lines using the second voltage corresponding to the middle-level state, is changed to a read operation that independently selects only the adjacent word line WL(n+1) is described, the read operation of the second embodiment, which simultaneously selects two adjacent word lines using the second voltage corresponding to the middle-level state, may be changed to a read operation that independently selects only the adjacent word line WL(n-1). Alternatively, the read operation of the second embodiment, which simultaneously selects two adjacent word lines using the first voltage corresponding to the low-level state, may be changed to a read operation that independently selects only the adjacent word line WL(n+1) or a read operation that independently selects only the adjacent word line WL(n-1), and the read operation of simultaneously selecting two adjacent word lines using the second voltage corresponding to the middle-level state may be executed without change.

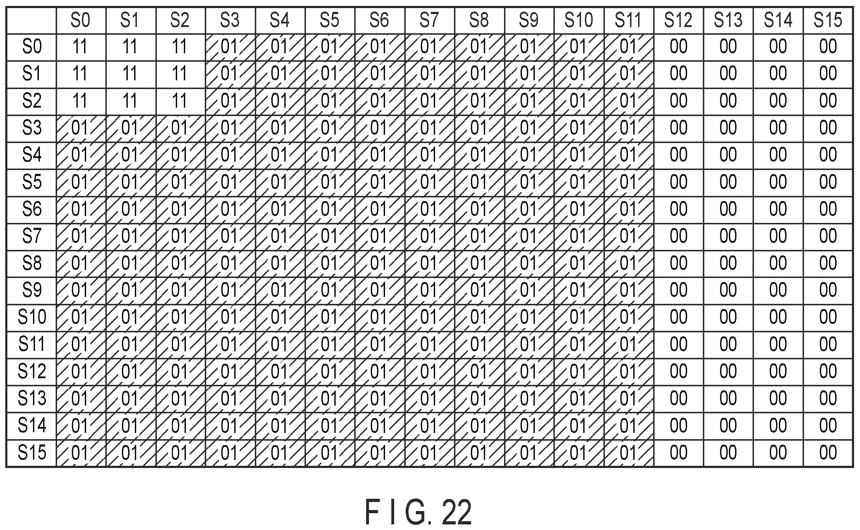

FIG. 22 is a diagram illustrating another example of a combination of states of two adjacent memory cells connected respectively to two adjacent word lines, which is determined by a read operation of simultaneously selecting two adjacent word lines and a read operation of selecting one of the two adjacent word lines independently in a nonvolatile memory device according to the third embodiment.

In FIG. 22, a case is assumed in which the read operation of the second embodiment that simultaneously selects two adjacent word lines (WL(n-1), WL(n+1)) using the second voltage corresponding to the middle-level state (e.g., a state equal to or lower than S11) is changed to the read operation that independently selects only the adjacent word line WL(n-1).

In FIG. 22, as in FIG. 13 and FIG. 18, S0 to S15 in a horizontal direction represent states of the memory cell transistors of the adjacent word line WL(n-1), and S0 to S15 in a vertical direction represent states of the memory cell transistors of the adjacent word line WL(n+1).

In FIG. 20, "11" indicates a combination of states of two adjacent memory cell transistors where data of the data latch S is "1" (i.e., is "LL") and data of the data latch T is "1" (i.e., is "MM"). "01" indicates a combination of states of two adjacent memory cell transistors where the data of the data latch S is "0" (i.e., is not "LL") and the data of the data latch T is "1" (i.e., is "MM"). "00" indicates a combination of states of two adjacent memory cell transistors where the data of the data latch S is "0" (i.e., is not "LL") and the data of the data latch T is "0" (i.e., is not "MM"). In addition, in FIG. 22, the combination indicated by "01" is shaded.

Note that, in each of the embodiments described above, the read voltage Vread applied to an unselected word line is only required to be equal to or higher than the voltage at which the memory cell transistor of the unselected word line turns on, and may be different for each word line or each bit line. For example, a higher read voltage VreadK than those of other unselected word lines may be applied to word lines WL(m±1) on both sides of a selected word line WL(m).

In addition, in each embodiment, the voltage Vcg_r applied when selecting WL(n±1) simultaneously does not necessarily have to be the same between WL(n+1) and WL(n-1). For example, by setting the voltage Vcg_r applied to WL(n-1) to be a predetermined value greater than the voltage Vcg_r applied to WL(n+1), it is possible to determine whether or not the condition that the threshold voltage of the memory cell transistor of WL(n+1) is lower than or equal to S2 and the threshold voltage of the memory cell transistor of WL(n-1) is lower than or equal to S4 is satisfied.

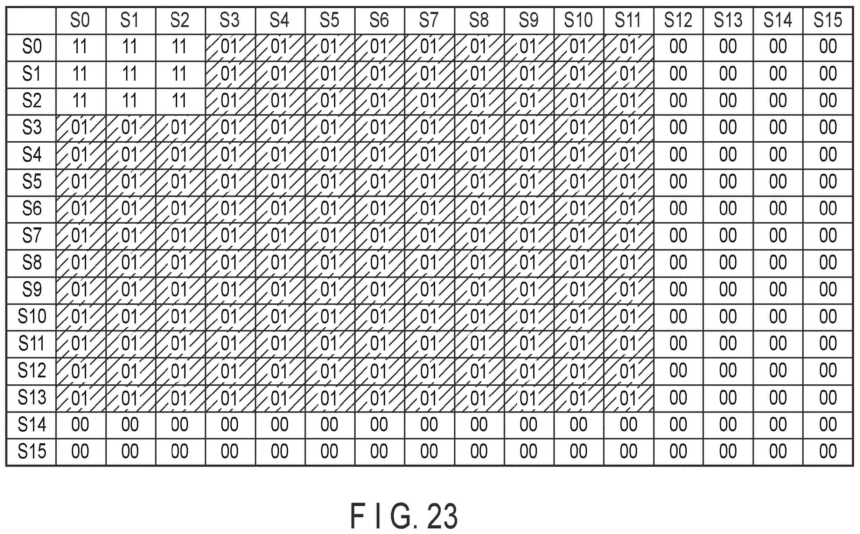

FIG. 23 is a diagram illustrating another example of a combination of states of two adjacent memory cells connected respectively to two adjacent word lines, which is determined by executing a read operation of simultaneously selecting two adjacent word lines twice in the nonvolatile memory device according to the second embodiment.

In FIG. 23, a case is assumed in which a voltage between S11 and S12 is applied to WL(n-1) as a middle-level side read voltage, and a voltage between S13 and S14 is applied to WL(n+1) as a middle-level side read voltage.

In addition, the order of the low-level state determination and the middle-level state determination may be reversed. The order of reading the C, M, and P data of WL(n) is not limited to the examples shown in each embodiment. In particular, by setting the read voltages of WL(n) in ascending or descending order, the read speed can be made faster than in the case where it is not set otherwise.

In addition, in each embodiment, an example has been shown in which two word lines WL(n±1) are selected simultaneously and voltage Vcg_r is applied; however, depending on the physical structure of the nonvolatile memory device, three or more word lines, for example WL(n11) and WL(n+2), may be selected simultaneously, or a plurality of word lines may be selected periodically or non-periodically, such as WL(n+2), WL(n+4), and WL(n+6), and voltage Vcg_r may be applied.

The arrangements or embodiments as described above are in accordance with the following numbered clauses.

### Clause 1

A nonvolatile memory device (4) comprising:
a plurality of memory cells (MT) connected in series, each of the plurality of memory cells (MT) being configured to store multiple bit data depending on which of a plurality of states with different threshold voltages the memory cell (MT) is in;
a first bit line connected to the plurality of memory cells (MT) connected in series;
a plurality of word lines (WL) connected respectively to the plurality of memory cells (MT); and
a control circuit (24) configured to execute at least a read operation with respect to the plurality of memory cells (MT), wherein
the control circuit (24) is further configured to:
   execute a read operation of simultaneously selecting two adjacent word lines (WL(n+1), WL(n-1)) adjacent to a read target word line (WL(n)) among the plurality of word lines (WL) by applying a first voltage to both the two adjacent word lines (WL(n+1), WL(n-1)), the first voltage being a voltage for determining whether or not both threshold voltages of two adjacent memory cells connected respectively to the two adjacent word lines (WL(n+1), WL(n-1)) are threshold voltages of a first state or lower, the first state being a low-level state among the plurality of states, having a threshold voltage lower than or equal to a predetermined threshold voltage;
   execute a first read operation of reading data from a read target memory cell connected to the read target word line (WL(n)) by sequentially applying to the read target word line (WL(n)) a plurality of different first read voltages that are determined based on assignment of data with respect to the plurality of states and 1-bit data to be read from the multiple bit data;
   execute a second read operation of reading data from the read target memory cell by sequentially applying to the read target word line (WL(n)) a plurality of second read voltages that are respectively lower than the plurality of first read voltages; and
   select one of first data, which is data read from the read target memory cell in the first read operation, and second data, which is data read from the read target memory cell in the second read operation, based on read data of the first bit line detected by the read operation of simultaneously selecting the two adjacent word lines (WL(n+1), WL(n-1)) using the first voltage, and output the selected data as read data corresponding to the read target memory cell.

### Clause 2

The nonvolatile memory device (4) of Clause 1, wherein:
the control circuit (24) is further configured to:
   when a value of the read data of the first bit line detected by the read operation of simultaneously selecting the two adjacent word lines (WL(n+1), WL(n-1)) is a value corresponding to a case where both of the two adjacent memory cells are turned on, select the second data as the read data corresponding to the read target memory cell; and
   when a value of the read data of the first bit line detected by the read operation of simultaneously selecting the two adjacent word lines (WL(n+1), WL(n-1)) is a value corresponding to a case where at least one of the two adjacent memory cells is turned off, select the first data as the read data corresponding to the read target memory cell.

### Clause 3

The nonvolatile memory device (4) of Clause 1, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages, and
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages.

### Clause 4

The nonvolatile memory device (4) of Clause 1, wherein
the control circuit (24) is further configured to:
execute an additional read operation of simultaneously selecting the two adjacent word lines (WL(n+1), WL(n-1)) by applying a second voltage to both the two adjacent word lines (WL(n+1), WL(n-1)), the second voltage being a voltage for determining whether or not both threshold voltages of the two adjacent memory cells are threshold voltages equal to or lower than a second state among the plurality of states, the second state being a middle-level state among the plurality of states, having a threshold voltage higher than the threshold voltage of the first state;
execute a third read operation of reading data from the read target memory cell by sequentially applying to the read target word line (WL(n)) a plurality of third read voltages that are respectively higher than the plurality of first read voltages; and
select one of the first data, the second data, and third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation of simultaneously selecting the two adjacent word lines (WL(n+1), WL(n-1)) using the second voltage, and output the selected data as the read data corresponding to the read target memory cell.

### Clause 5

The nonvolatile memory device (4) of Clause 4, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

### Clause 6

The nonvolatile memory device (4) of Clause 1, wherein
the control circuit (24) is further configured to:
execute an additional read operation with respect to one of adjacent word lines of the two adjacent word lines (WL(n+1), WL(n-1)) by applying a second voltage to the one of the adjacent word lines, the second voltage being a voltage for determining whether or not a threshold voltage of an adjacent memory cell connected to the one of the adjacent word lines is a threshold voltage of a second state or lower, the second state being a middle-level state among the plurality of states, which is higher than the first state;
execute a third read operation of reading data from the read target memory cell by sequentially applying to the read target word line (WL(n)) a plurality of third read voltages that are respectively higher than the plurality of first read voltages; and
select one of the first data, the second data, and the third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation with respect to the one of the adjacent word lines using the second voltage, and output the selected data as the read data corresponding to the read target memory cell.

### Clause 7

The nonvolatile memory device (4) of Clause 6, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

### Clause 8

A method of controlling a nonvolatile memory device (4) including a plurality of memory cells (MT) connected in series, a first bit line connected to the plurality of memory cells (MT) connected in series, and a plurality of word lines (WL) connected respectively to the plurality of memory cells (MT), each of the plurality of memory cells (MT) being configured to store multiple bit data depending on which of a plurality of states with different threshold voltages the memory cell (MT) is in, the method comprising:
executing a read operation of simultaneously selecting two adjacent word lines (WL(n+1), WL(n-1)) adjacent to a read target word line (WL(n)) among the plurality of word lines (WL) by applying a first voltage to both of the two adjacent word lines (WL(n+1), WL(n-1)), the first voltage being a voltage for determining whether or not both threshold voltages of two adjacent memory cells connected to the two adjacent word lines (WL(n+1), WL(n-1)) are threshold voltages of a first state or lower;
executing a first read operation of reading data from a read target memory cell connected to the read target word line (WL(n)) by sequentially applying to the read target word line a plurality of different first read voltages that are determined based on assignment of data with respect to the plurality of states and 1-bit data to be read from the multiple bit data;
executing a second read operation of reading data from the read target memory cell by sequentially applying to the read target word line (WL(n)) a plurality of second read voltages that are respectively lower than the plurality of first read voltages; and
selecting one of first data, which is data read from the read target memory cell in the first read operation, and second data, which is data read from the read target memory cell in the second read operation, based on read data of the first bit line detected by the read operation of simultaneously selecting the two adjacent word lines (WL(n+1), WL(n-1)) using the first voltage, and outputting the selected data as read data corresponding to the read target memory cell, wherein
the first state is a low-level state among the plurality of states, having a threshold voltage lower or equal to a predetermined threshold voltage.

### Clause 9

The method of Clause 8, wherein
the selecting one of the first data and the second data includes:
selecting the second data as the read data corresponding to the read target memory cell in response to that a value of read data of the first bit line detected by the read operation of simultaneously selecting the two adjacent word lines (WL(n+1), WL(n-1)) is a value corresponding to a case where both of the two adjacent memory cells are turned on; and
selecting the first data as the read data corresponding to the read target memory cell in response that a value of read data of the first bit line detected by the read operation of simultaneously selecting the two adjacent word lines (WL(n+1), WL(n-1)) is a value corresponding to a case where at least one of the two adjacent memory cells is turned off.

### Clause 10

The method of Clause 8, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages, and
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages.

### Clause 11

The method of Clause 8, further comprising:
executing an additional read operation of simultaneously selecting the two adjacent word lines (WL(n+1), WL(n-1)) by applying a second voltage to both the two adjacent word lines (WL(n+1), WL(n-1)), the second voltage being a voltage for determining whether or not both threshold voltages of the two adjacent memory cells are threshold voltages equal to or lower than a second state among the plurality of states;
executing a third read operation of reading data from the read target memory cell by sequentially applying to the read target word line (WL(n)) a plurality of third read voltages that are respectively higher than the plurality of first read voltages; and
selecting one of the first data, the second data, and third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation of simultaneously selecting the two adjacent word lines (WL(n+1), WL(n-1)) using the second voltage, and outputting the selected data as the read data corresponding to the read target memory cell, wherein
the second state is a middle-level state among the plurality of states, having a threshold voltage higher than the threshold voltage of the first state.

### Clause 12

The method of Clause 11, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

### Clause 13

The method of Clause 8, further comprising:
executing an additional read operation with respect to one of adjacent word lines of the two adjacent word lines (WL(n+1), WL(n-1)) by applying a second voltage to the one of the adjacent word lines, the second voltage being a voltage for determining whether or not a threshold voltage of an adjacent memory cell connected to the one of the adjacent word lines is a threshold voltage of a second state or lower;
executing a third read operation of reading data from the read target memory cell by sequentially applying to the read target word line (WL(n)) a plurality of third read voltages that are respectively higher than the plurality of first read voltages; and
selecting one of the first data, the second data, and the third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation with respect to the one of the adjacent word lines using the second voltage, and outputting the selected data as the read data corresponding to the read target memory cell, wherein
the second state is a middle-level state among the plurality of states, which is higher than the first state.

### Clause 14

The method of Clause 13, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the scope of the inventions. The accompanying claims are intended to cover such forms or modification as would fall within the scope of the inventions.

## Claims

1. A nonvolatile memory device (4) comprising:
a plurality of memory cells (MT) connected in series, each of the plurality of memory cells (MT) being configured to store multiple bit data depending on which of a plurality of states with different threshold voltages the memory cell (MT) is in;
a first bit line connected to the plurality of memory cells (MT) connected in series;
a plurality of word lines (WL) connected respectively to the plurality of memory cells (MT); and
a control circuit (24) configured to execute at least a read operation with respect to the plurality of memory cells (MT), wherein
the control circuit (24) is further configured to:
execute a read operation of simultaneously selecting two adjacent word lines (WL(n+1), WL(n-1)) adjacent to a read target word line (WL(n)) among the plurality of word lines (WL) by applying a first voltage to both the two adjacent word lines (WL(n+1), WL(n-1)), the first voltage being a voltage for determining whether or not both threshold voltages of two adjacent memory cells connected respectively to the two adjacent word lines (WL(n+1), WL(n-1)) are threshold voltages of a first state or lower, the first state being a low-level state among the plurality of states, having a threshold voltage lower than or equal to a predetermined threshold voltage;
execute a first read operation of reading data from a read target memory cell connected to the read target word line (WL(n)) by sequentially applying to the read target word line (WL(n)) a plurality of different first read voltages that are determined based on assignment of data with respect to the plurality of states and 1-bit data to be read from the multiple bit data;
execute a second read operation of reading data from the read target memory cell by sequentially applying to the read target word line (WL(n)) a plurality of second read voltages that are respectively lower than the plurality of first read voltages; and
select one of first data, which is data read from the read target memory cell in the first read operation, and second data, which is data read from the read target memory cell in the second read operation, based on read data of the first bit line detected by the read operation of simultaneously selecting the two adjacent word lines (WL(n+1), WL(n-1)) using the first voltage, and output the selected data as read data corresponding to the read target memory cell.

2. The nonvolatile memory device (4) of claim 1, wherein:
the control circuit (24) is further configured to:
when a value of the read data of the first bit line detected by the read operation of simultaneously selecting the two adjacent word lines (WL(n+1), WL(n-1)) is a value corresponding to a case where both of the two adjacent memory cells are turned on, select the second data as the read data corresponding to the read target memory cell; and
when a value of the read data of the first bit line detected by the read operation of simultaneously selecting the two adjacent word lines (WL(n+1), WL(n-1)) is a value corresponding to a case where at least one of the two adjacent memory cells is turned off, select the first data as the read data corresponding to the read target memory cell.

3. The nonvolatile memory device (4) of claim 1 or 2, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages, and
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages.

4. The nonvolatile memory device (4) of any preceding claim, wherein
the control circuit (24) is further configured to:
execute an additional read operation of simultaneously selecting the two adjacent word lines (WL(n+1), WL(n-1)) by applying a second voltage to both the two adjacent word lines (WL(n+1), WL(n-1)), the second voltage being a voltage for determining whether or not both threshold voltages of the two adjacent memory cells are threshold voltages equal to or lower than a second state among the plurality of states, the second state being a middle-level state among the plurality of states, having a threshold voltage higher than the threshold voltage of the first state;
execute a third read operation of reading data from the read target memory cell by sequentially applying to the read target word line (WL(n)) a plurality of third read voltages that are respectively higher than the plurality of first read voltages; and
select one of the first data, the second data, and third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation of simultaneously selecting the two adjacent word lines (WL(n+1), WL(n-1)) using the second voltage, and output the selected data as the read data corresponding to the read target memory cell.

5. The nonvolatile memory device (4) of claim 4, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

6. The nonvolatile memory device (4) of any one of claims 1 to 3, wherein
the control circuit (24) is further configured to:
execute an additional read operation with respect to one of adjacent word lines of the two adjacent word lines (WL(n+1), WL(n-1)) by applying a second voltage to the one of the adjacent word lines, the second voltage being a voltage for determining whether or not a threshold voltage of an adjacent memory cell connected to the one of the adjacent word lines is a threshold voltage of a second state or lower, the second state being a middle-level state among the plurality of states, which is higher than the first state;
execute a third read operation of reading data from the read target memory cell by sequentially applying to the read target word line (WL(n)) a plurality of third read voltages that are respectively higher than the plurality of first read voltages; and
select one of the first data, the second data, and the third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation with respect to the one of the adjacent word lines using the second voltage, and output the selected data as the read data corresponding to the read target memory cell.

7. The nonvolatile memory device (4) of claim 6, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

8. A method of controlling a nonvolatile memory device (4) including a plurality of memory cells (MT) connected in series, a first bit line connected to the plurality of memory cells (MT) connected in series, and a plurality of word lines (WL) connected respectively to the plurality of memory cells (MT), each of the plurality of memory cells (MT) being configured to store multiple bit data depending on which of a plurality of states with different threshold voltages the memory cell (MT) is in, the method comprising:
executing a read operation of simultaneously selecting two adjacent word lines (WL(n+1), WL(n-1)) adjacent to a read target word line (WL(n)) among the plurality of word lines (WL) by applying a first voltage to both of the two adjacent word lines (WL(n+1), WL(n-1)), the first voltage being a voltage for determining whether or not both threshold voltages of two adjacent memory cells connected to the two adjacent word lines (WL(n+1), WL(n-1)) are threshold voltages of a first state or lower;
executing a first read operation of reading data from a read target memory cell connected to the read target word line (WL(n)) by sequentially applying to the read target word line (WL(n)) a plurality of different first read voltages that are determined based on assignment of data with respect to the plurality of states and 1-bit data to be read from the multiple bit data;
executing a second read operation of reading data from the read target memory cell by sequentially applying to the read target word line (WL(n)) a plurality of second read voltages that are respectively lower than the plurality of first read voltages; and
selecting one of first data, which is data read from the read target memory cell in the first read operation, and second data, which is data read from the read target memory cell in the second read operation, based on read data of the first bit line detected by the read operation of simultaneously selecting the two adjacent word lines (WL(n+1), WL(n-1)) using the first voltage, and outputting the selected data as read data corresponding to the read target memory cell, wherein
the first state is a low-level state among the plurality of states, having a threshold voltage lower or equal to a predetermined threshold voltage.

9. The method of claim 8, wherein
the selecting one of the first data and the second data includes:
selecting the second data as the read data corresponding to the read target memory cell in response to that a value of read data of the first bit line detected by the read operation of simultaneously selecting the two adjacent word lines (WL(n+1), WL(n-1)) is a value corresponding to a case where both of the two adjacent memory cells are turned on; and
selecting the first data as the read data corresponding to the read target memory cell in response that a value of read data of the first bit line detected by the read operation of simultaneously selecting the two adjacent word lines (WL(n+1), WL(n-1)) is a value corresponding to a case where at least one of the two adjacent memory cells is turned off.

10. The method of claim 8 or 9, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages, and
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages.

11. The method of any one of claims 8 to 10, further comprising:
executing an additional read operation of simultaneously selecting the two adjacent word lines (WL(n+1), WL(n-1)) by applying a second voltage to both the two adjacent word lines (WL(n+1), WL(n-1)), the second voltage being a voltage for determining whether or not both threshold voltages of the two adjacent memory cells are threshold voltages equal to or lower than a second state among the plurality of states;
executing a third read operation of reading data from the read target memory cell by sequentially applying to the read target word line (WL(n)) a plurality of third read voltages that are respectively higher than the plurality of first read voltages; and
selecting one of the first data, the second data, and third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation of simultaneously selecting the two adjacent word lines (WL(n+1), WL(n-1)) using the second voltage, and outputting the selected data as the read data corresponding to the read target memory cell, wherein
the second state is a middle-level state among the plurality of states, having a threshold voltage higher than the threshold voltage of the first state.

12. The method of claim 11, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.

13. The method of any one of claims 8 to 10, further comprising:
executing an additional read operation with respect to one of adjacent word lines of the two adjacent word lines (WL(n+1), WL(n-1)) by applying a second voltage to the one of the adjacent word lines, the second voltage being a voltage for determining whether or not a threshold voltage of an adjacent memory cell connected to the one of the adjacent word lines is a threshold voltage of a second state or lower;
executing a third read operation of reading data from the read target memory cell by sequentially applying to the read target word line (WL(n)) a plurality of third read voltages that are respectively higher than the plurality of first read voltages; and
selecting one of the first data, the second data, and the third data, which is data read from the read target memory cell in the third read operation, based on a combination of read data of the first bit line detected by the read operation of simultaneously selecting the two adjacent word lines (WL(n+1), WL(n-1)) using the first voltage and read data of the first bit line detected by the additional read operation with respect to the one of the adjacent word lines using the second voltage, and outputting the selected data as the read data corresponding to the read target memory cell, wherein
the second state is a middle-level state among the plurality of states, which is higher than the first state.

14. The method of claim 13, wherein
the first read operation includes: an operation of sequentially applying the plurality of first read voltages to the read target word line (WL(n)); and an operation of determining a value of 1-bit data read from the read target memory cell in the first read operation by executing a logical operation with respect to a plurality of 1-bit data which are read from the read target memory cell and which correspond respectively to the plurality of first read voltages,
the second read operation includes: an operation of sequentially applying the plurality of second read voltages to the read target word line (WL(n)); and an operation of determining a value of 1-bit data read from the read target memory cell in the second read operation by executing the logical operation with respect to a plurality of 1-bit data which are read from the read target memory cell and which correspond respectively to the plurality of second read voltages, and
the third read operation includes: an operation of sequentially applying the plurality of third read voltages to the read target word line (WL(n)); and an operation of determining a value of 1-bit data read from the read target memory cell in the third read operation by executing the logical operation with respect to a plurality of 1-bit data which are read from the read target memory cell and which correspond respectively to the plurality of third read voltages.
